## Europäisches Patentamt

## European Patent Office

## Office européen des brevets

(19)

(11) Veröffentlichungsnummer: **0 155 702**
**A2**

(12) # EUROPÄISCHE PATENTANMELDUNG

(21) Anmeldenummer: **85103409.0**

(22) Anmeldetag: **22.03.85**

(51) Int. Cl.⁴: **H 03 M 1/36**

(30) Priorität: **23.03.84 DE 3410796**
**10.07.84 DE 3425399**

(43) Veröffentlichungstag der Anmeldung:
**25.09.85 Patentblatt 85/39**

(84) Benannte Vertragsstaaten:
**FR GB IT**

(71) Anmelder: **Werba, Hans**
**Theresienstrasse 11**
**D-8390 Passau(DE)**

(72) Erfinder: **Werba, Hans**
**Theresienstrasse 11**
**D-8390 Passau(DE)**

(72) Erfinder: **Schlögel, Rudolf**
**Im Tal 9**
**A-6060 Absam (Tirol)(AT)**

(74) Vertreter: **Kador . Klunker . Schmitt-Nilson . Hirsch**
**Corneliusstrasse 15**
**D-8000 München 5(DE)**

(54) Analog/Digital-Wandlung.

(57) Analog/Digital-Wandler mit einer von der erforderlichen Bit-Auflösung abhängenden Anzahl Schwellenwertschaltungen, deren Eingängen das zu digitalisierende Analogsignal zugeführt wird und an deren Ausgängen das digitalisierte Signal verfügbar ist. Dabei ist den Eingängen der Schwellenwertschaltungen eine Modulatorschaltung vorgeschaltet, in der das zu digitalisierende Analogsignal auf eine frequenzkonstante Trägerfrequenz in Amplitudenmodulation aufmoduliert wird.

FIG. 1

0155702

## Analog/Digital-Wandlung

Die Erfindung betrifft einen Analog/Digital-Wandler und ein Verfahren zur Analog/Digitalwandlung.

Herkömmliche Analog/Digital-Wandler (im folgenden A/D-Wandler bezeichnet) weisen als Schwellenwertschaltungen üblicherweise Komparatorschaltungen auf, die Transistoren enthalten, die je nach dem, ob der Schwellenwert überschritten ist oder nicht, im Sperrbereich oder im Sättigungsbereich arbeiten. Aufgrund der Zeitverzögerungseffekte, die zeitweise im Sättigungsbereich arbeitende Transistoren mit sich bringen, setzen solche A/D-Wandler dem zu digitalisierenden Analog-Signal hinsichtlich der maximalen Frequenz Grenzen, die häufig nicht akzeptabel sind.

A/D-Wandler müssen normalerweise in einem recht breiten Frequenzband arbeiten, in dem das zu digitalisierende Analogsignal liegen kann. Aufgrund des komplexen Eingangswiderstandes kommt es zu einer frequenzabhängigen Schaltschwelle der in üblichen A/D-Wandlern verwendeten Schwellenwertschaltungen, so daß die Genauigkeit der Digitalisierung insbesondere im oberen verarbeitbaren Frequenzbereich abnimmt. Außerdem muß das umzusetzende Analogsignal für eine zuverlässige und korrekte Digitalisierung eine Mindestleistung aufweisen.

Der Erfindung liegt die Aufgabe zugrunde, gegen derartige Beeinträchtigungen Abhilfe zu schaffen und insbesondere
unabhängig von der Leistung des umzusetzenden Analogsignals zu werden und Analogsignale mit höherer Frequenz
umsetzen zu können, als es mit den herkömmlichen A/D-
Wandlern möglich ist.

Verfahrens- und vorrichtungsmäßige Lösungen dieser Aufgabe
sind in den Ansprüchen angegeben und können gemäß den
Unteransprüchen vorteilhaft weitergebildet werden.

Eine vorrichtungsmäßige Lösung besteht in einem A/D-
Wandler mit einer von der erforderlichen Quantisierungsauflösung abhängenden Anzahl Schwellenwertschaltungen, deren
Eingängen das zu digitalisierende Analogsignal zugeführt
wird und an deren Ausgängen das digitalisierte Signal
verfügbar ist,
wobei den Eingängen der Schwellenwertschaltungen eine
Modulatorschaltung vorgeschaltet ist, in der das zu digitalisierende Analogsignal auf eine frequenzkonstante
Trägerfrequenz in Amplitudenmodulation aufmoduliert wird.

Dadurch, daß die Schwellenwertschaltungen dieses erfindungsgemäßen A/D-Wandlers nicht direkt mit dem umzusetzenden Analogsignal beaufschlagt werden sondern mit der mit dem Analogsignal amplitudenmodulierten Trägerfrequenz, ist
sichergestellt, daß die Schwellenwertschaltungen mit einer
festen Frequenz betrieben werden. Vom frequenzabhängigen
Verhalten der Schwellenwertschaltungen herrührende Beeinflussungen der Umsetzungsgenauigkeit sind somit ausgeschaltet. Die den Schwellenwertschaltungen angebotene
Leistung wird nicht mehr durch das Analogsignal bestimmt sondern durch die Trägerfrequenz, deren Leistung
problemlos eingestellt werden kann.

0155702

In besonders bevorzugter Weise werden erfindungsgemäß die Schwellenwertschaltungen mit Diodenschaltungen aufgebaut, wobei eine besonders bevorzugte Ausführungsform gemäß Anspruch 6 ausgebildet ist. Bei Verwendung von Diodennetzwerken in den Schwellenwertschaltungen kann man besonders hohe Frequenzen verarbeiten, wobei man mit bestimmten Diodentypen, beispielsweise Schottky-Dioden, PIN-Dioden u.s.w., bis in den GHz-Bereich vordringen kann.

Bei einer Weiterbildung der Erfindung nach Anspruch 8 wird die Umsetzung des Analogsignals in ein amplitudenmoduliertes Hochfrequenzsignal besonders vorteilhaft.
Bei dieser Ausführungsform verwendet man, in bekannter Weise, zwischen dem Ausgang einer jeden Schwellenwertschaltung und dem Eingang des ihr nachgeschalteten Speichers einen Kondensator, um die Gleichspannungsanteile an den Ausgängen der einzelnen Schwellenwertschaltungen, die unterschiedlich groß sind, abzutrennen. Würde man nun nicht die erfindungsgemäße Maßnahme zur Umsetzung des amplitudenmodulierten Hochfrequenzsignals anwenden sondern die Schwellenwertschaltungen direkt mit dem umzusetzenden Analogsignal beaufschlagen, würde am Eingang der einzelnen Speicher das Überschreiten des jeweiligen Schwellenwertes nicht während der ganzen Überschreitungsdauer angezeigt sondern nur in den Momenten des Durchlaufens der Schwelle in der einen oder der anderen Richtung, und zwar in Form von Differenzierungsimpulsen, die zu den Zeitpunkten dieses Durchlaufens der Schwelle auftreten.
Aufgrund der Verwendung des mit dem Analogsignal amplitudenmodulierten Hochfrequenzsignals erreicht man, daß auf der Ausgangsseite des jeweiligen Kondensators, also am Eingang des jeweiligen Speichers, eine Überschreitung des jeweiligen Schwellenwertes während der gesamten Dauer dieser Überschreitung angezeigt bleibt.

Bei einer verfahrensmäßigen Lösung wird ein Trägerfrequenzsignal mit dem zu digitalisierenden Analogsignal amplitudenmoduliert und das modulierte Trägergrequenzsignal hinsichtlich seiner Amplitude bewertet. Hierfür wird
ein Bezugssignal mit der Frequenz des Trägerfrequenzsignals in einer von der erforderlichen Quantisierungsfeinheit abhängenden Anzahl von Amplitudenstufen erzeugt, das modulierte Trägerfrequenzsignal amplitudenmäßig mit jeder der einzelnen Amplitudenstufen des Bezugssignals verglichen  und bei Amplitudenübereinstimmung zwischen dem modulierten Trägerfrequenzsignal und
einer Amplitudenstufe des Bezugssignals ein erster binärer Logikwert (z. B. "0") und ansonsten der zweite
binärer Logikwert (z. B. "1") zugeordnet.

Das Kernprinzip 'dieser Lösung besteht darin, ein
mit dem zu digitalisierenden Analogsignal amplitudenmoduliertes Trägerfrequenzsignal mit einem gleichfrequenten
Bezugs-Trägerfrequenzsignal mit gleicher oder entgegengesetzter Phasenlage in amplitudenmäßigen       Abstufungen
in einer der erforderlichen Bit-Auflösung entsprechenden
Stufenzahl zu vergleichen, und zwar gleichzeitig hinsichtlich aller Stufen. An der Stufe, an welcher das amplitudenmodulierte Trägerfrequenzsignal und das Bezugs-Trägerfrequenzsignal gleiche Amplitude aufweisen, kommt es bei
Verwendung entgegengesetzter Phasenlage zu einer echten
Auslöschung und bei Verwendung gleicher Phasenlage zu einer quasi-Auslöschung, die sich als ein recht scharfes

0155702

Kriterium für die momentane Lage des Amplitudenwerts des
zu digitalisierenden Analogsignals erweisen.

Eine besonders hohe Auflösungsempfindlichkeit der Analog/
Digital-Umwandlung kann man erreichen, wenn man in Weiterbildung dieser Erfindungsidee auch das Bezugs-Trägerfrequenzsignal mit dem zu digitalisierenden Analogsignal amplitudenmoduliert, jedoch mit einer Phasenlage des Analogsignals, die derjenigen entgegengesetzt ist, mit welcher
die Amplitudenmodulation des anderen modulierten Trägerfrequenzsignals durchgeführt wird. Durch diese Maßnahme
wird die erreichbare Digitalisierungsschärfe nochmals verdoppelt.

Auch bei der Verwendung eines amplitudenmodulierten Trägerfrequenzsignals als Bezugs-Trägerfrequenz kann man die
beiden amplitudenmodulierten Trägerfrequenzsignale in
gleicher oder entgegengesetzter Phasenlage miteinander
vergleichen. Bei entgegengesetzter Phasenlage der beiden
zu vergleichenden Trägerfrequenzsignale verwendet man für
die Amplitudenvergleichsschaltungen
vorteilhafterweise                als Null-Detektoren wirkende Verstärker, die eine gegenseitige Auslöschung der
beiden zu vergleichenden Trägerfrequenzsignale durch eine
Nullwert-Anzeige aufzeigen, der beispielsweise der Logikwert "0" zugeordnet werden kann. Bei der Ausführungsform
mit gleicher        Phasenlage der beiden zu vergleichenden Trägerfrequenzsignale verwendet man für die einzelnen Amplitudenvergleichsschaltungen vorteilhafterweise
Differenzverstärker, die bei Übereinstimmung der Amplituden der beiden von ihnen zu vergleichenden Trägerfrequenzsignale am Ausgang ebenfalls ein Nullwert-Signal abgeben
können und somit quasi wie eine Auslöschungsanzeige wirken.

Die Anzahl der für den A/D-Wandler verwendeten Amplitudenvergleichsschaltungen hängt von der erforderlichen Quantisierungsfeinheit oder Bit-Auflösung ab. Insbesondere bei der Verwendung einer relativ
kleinen Anzahl von parallel arbeitenden Amplitudenvergleichsschaltungen kann es vorkommen, daß gleiche Amplituden der beiden zu vergleichenden Trägerfrequenzsignale
bzw. deren gegenseitige Auslöschung nicht exakt an einer
der Vergleichsstufen, sondern zwischen zwei Vergleichsstufen auftritt. An der nächstgelegenen Vergleichsstufe tritt
dann keine exakte Auslöschung bzw. quasi-Auslöschung auf,
sondern ein von Null verschiedenes Ausgangssignal, dessen
Höhe von der Digitalisierungsauflösung, also von der Anzahl der verwendeten Vergleichsstufen, abhängt. Um auch
für diese Fälle eine eindeutige Digitalisierung des Analogsignals zu gewährleisten, ist es besonders empfehlenswert,
für die Amplitudenvergleichsschaltungen Schaltungsanordnungen mit Schwellenwertverhalten einzusetzen oder diesen Amplitudenvergleichsschaltungen Schwellenwertschaltungen
nachzuordnen, mit deren Schwelle die Unterscheidungsgrenze zwischen den beiden binären Logikwerten "0" und "1"
festgelegt werden kann.

Mit dem in den Patentansprüchen verwendeten Begriff
"Relativ-Amplitudenstufe" soll zum Ausdruck gebracht
werden, daß die einzelnen Amplitudenstufen nicht feste absolute Amplitudenwerte aufweisen sondern relative Amplitudenwerte, die jeweils vom momentanen Spannungswert
des amplitudenmodulierten Trägerfrequenzsignals abhängen und
nur in ihrer relativen Größe zu diesem momentanen Spannungswert gleich bleiben.

Wenn bei dieser Lösung der Erfindung von Trägerfrequenzsignalen die Rede ist, so soll dies Frequenzen
bis herab zu Null einschließen. Man kann nämlich als
Träger auch eine Gleichspannung verwenden, deren Amplitude von dem zu digitalisierenden Analogsignal moduliert
wird. Für den Fall, daß nur der eine Träger moduliert
wird, erhalten die Bewertungsschaltungen einer Seite die
modulierte Gleichspannung und auf der anderen Seite die
konstante, nicht modulierte Gleichspannung. Für den Fall,
daß beide Träger moduliert werden, erhalten die einzelnen
Amplitudenvergleichsschaltungen an ihren beiden Eingängen
die beiden gegenphasig modulierten Gleichspannungssignale.

Wie bereits erwähnt, kann man bei dieser Lösung dann, wenn
man auch das Bezugs-Trägerfrequenzsignal mit dem zu digitalisierenden Analogsignal amplitudenmoduliert, eine besonders hohe Auflösungsempfindlichkeit der A/D-Wandlung
erreichen. Hierfür ist bei der beschriebenen Lösung der
Einsatz zweier Widerstandsketten erforderlich.

Bei einer besonders vorteilhaften Weiterbildung dieser Lösungsidee kann man diese hohe Auflösungsempfindlichkeit
jedoch auch mit einer einzigen Widerstandskette erreichen.
Dabei geht man so vor, daß man das zu digitalisierende
Analogsignal in einer ersten Phasenlage einem ersten
Trägerfrequenzsignal und in einer zur ersten Phasenlage
entgegengesetzten zweiten Phasenlage einem zweiten Trägerfrequenzsignal, dessen Frequenz mit derjenigen des ersten
Trägerfrequenzsignals übereinstimmt, dessen Phasenlage
jedoch zu derjenigen des ersten Trägerfrequenzsignals
entgegengesetzt ist, amplitudenmäßig aufmoduliert, das
amplitudenmodulierte erste Trägerfrequenzsignal in das eine Ende und das amplitudenmodulierte zweite Trägerfrequenzsignal in das andere Ende dieser Widerstandskette einspeist,
denjenigen Spannungsteilerpunkt der Widerstandskette ermittelt, an dem sich eine Aufhebung der beiden Endes in
die Widerstandskette eingespeisten Trägerfrequenzsignale
ergibt, und diesem Spannungsteilerpunkt einen ersten Binärwert (z.B. "0") und allen anderen Spannungsteilerpunkten
den anderen Binärwert (z.B. "1") zuordnet, wobei das so
erhaltene Binärwertmuster den umgewandelten Analogsignalwert darstellt.

Auch hier gilt wieder, daß die Trägerfrequenz bis auf Null
herabreichen kann. In diesem Fall wird das zu digitalisierende Analogsignal einem ersten Gleichspannungssignal
einer ersten Polarität und einem zweiten Gleichspannungssignal gleichen Betrages aber entgegengesetzter Polarität
aufmoduliert, wobei das amplitudenmodulierte erste Gleichspannungssignal in das eine und das amplitudenmodulierte
zweite Gleichspannungssignal in das andere Ende der Widerstandskette eingespeist wird und derjenige Spannungsteilerpunkt der Widerstandskette ermittelt wird, an dem sich eine
Aufhebung der beiden Endes in die Widerstandskette eingespeisten Gleichspannungssignale ergibt.

Bei einem nach diesem Verfahren arbeitenden, bevorzugten
A/D-Wandler sind zwei Amplitudenmodulatoren vorgesehen,
denen je das Trägerfrequenzsignal bzw. die Gleichspannung
und das modulierende Analogsignal mit den angegebenen
Phasenbeziehungen zugeführt werden. An die Spannungsteilerpunkte der Widerstandskette sind Null-Detektoren angeschlossen, mittels welchen derjenige Spannungsteilerpunkt
ermittelt wird, an dem sich aufgrund der Aufhebung der
beiden Endes eingespeisten modulierten Signale der Spannungswert Null ergibt. Dem an diesem Spannungsteilerpunkt angeschlossenen Null-Detektor wird dann beispielsweise der Binärwert "0" zugeordnet. Allen anderen Null-Detektoren wird der Binärwert "1" zugeordnet. Aus diesem Binärwertmuster, nämlich der Lage des Binärwertes "0" innerhalb der restlichen Binärwerte "1", ergibt sich der Digitalcode des digitalisierten Analogsignals. Mittels eines an sich bekannten Prioritätsdecoders kann man dieses Binärwertmuster beispielsweise in einen Dualcode umwandeln.

Ein Kernpunkt dieser Erfindungslösung liegt darin, daß man aufgrund der gegenphasigen Amplitudenmodulation der gleichfrequenten gegenphasigen Trägerfrequenzsignale bzw. zweier Gleichspannungen gleichen Betrages aber entgegengesetzten Vorzeichens erreicht, daß die Aufhebung der in die beiden Enden der Widerstandskette eingespeisten modulierten Signale immer an irgendeiner Stelle der Widerstandskette auftritt.

Eine besonders bevorzugte Weiterbildung dieser Erfindungslösung, bei der man mit einer relativ kleinen Anzahl von Widerständen eine sehr hohe Quantisierungsauflösung erreichen kann, besitzt eine zweite Widerstandskette. Hierbei fungiert die erste Widerstandskette als Grobteiler- oder Grobwiderstandskette und dient die zweite Widerstandskette als Feinteiler- oder Feinwiderstandskette. Das von der Grobteilerkette abgenommene Binärwertmuster und das von der Feinteilerkette abgenommene Binärwertmuster bilden zusammen den digitalisierten Analogsignalwert. In besonders bevorzugter Form ist jeder der beiden Widerstandsketten ein Prioritätsdecoder nachgeordnet, von denen einer die höherwertigen und der andere die niederwertigen Bits des dualcodierten Analogsignalwertes liefert.

Bei dieser Weiterbildung wird so vorgegangen, daß zunächst derjenige Widerstand der Grobteilerkette ermittelt wird, an dessen beiden Enden Spannungswerte entgegengesetzter
Polarität auftreten. Der am einen Endpunkt dieses Widerstandes auftretende Spannungswert wird dann in das eine
Ende der Feinteilerkette direkt und in deren anderes Ende
nach Überlagerung einer Gleichspannung eingespeist. Diese
überlagerte Gleichspannung ist gleich dem Spannungsabfall
über demjenigen Widerstand der Grobteilerkette, an dessen
beiden Enden Spannungswerte entgegengesetzter Polarität
festgestellt worden sind. Zur Vereinfachung wird man in
besonders bevorzugter Weise alle Widerstände der Grobteilerkette gleich groß machen, so daß man die überlagerte
Gleichspannung konstant halten kann.

Die in die beiden Enden der Feinteilerkette eingespeisten
Gleichspannungen kann man vor dieser Einspeisung noch verstärken, um höhere Spannungsunterschiede an den einzelnen
Spannungsteilerpunkten der Feinteilerkette zu erzielen und
damit eine höhere Digitalisierungsschärfe.

Eine besonders bevorzugte Ausführungsform eines derartigen
A/D-Wandlers ist im Anspruch 34 angegeben.

Im Zusammenhang mit der vorliegenden Erfindung sind unter
Widerständen, aus denen die Widerstandsketten aufgebaut sind,
ohmsche Widerstände, Induktivitäten und Kapazitäten oder
Kombinationen hiervon zu verstehen.

Im Zusammenhang mit der vorliegenden Erfindung sind die
Begriffe "gleiche Amplituden", "Aufhebung oder Auslöschung
der Spannungswerte" u.s.w. nicht in dem strengen Sinn
einer vollkommenen Amplitudengleichheit bzw. vollkommenen
Aufhebung oder Auslöschung zu verstehen. Es sind auch die Fälle mit einzubeziehen, in denen gleiche Amplituden
bzw. eine Aufhebung oder Auslöchung nur in etwa oder
im wesentlichen erreicht wird, weil bei den gewählten
Quantisierungsstufen der umzusetzende Analogsignalwert zwischen zwei Quantisierungstufen liegt.


Die Erfindung wird nun zusammen mit weiteren Erfindungs-,
Aufgaben- und Vorteilsaspekten anhand von Ausführungsformen näher erläutert.
In den Zeichnungen zeigen:

Fig. 1    ein Blockschaltbild einer ersten Ausführungsform
          eines erfindungsgemäßen A/D-Wandlers;

Fig. 2    eine besonders bevorzugte Ausführungsform einer
          für einen solchen A/D-Wandler geeigneten Schwellenwertschaltung;

Fig. 3    eine zweite Ausführungsform eines erfindungsgemäßen A/D-Wandlers;

Fig. 4    eine dritte Ausführungsform eines erfindungsgemäßen A/D-Wandlers;

Fig. 5    eine erste Ausführungsform einer Amplitudenvergleichsschaltung, die für die A/D-Wandler gemäß

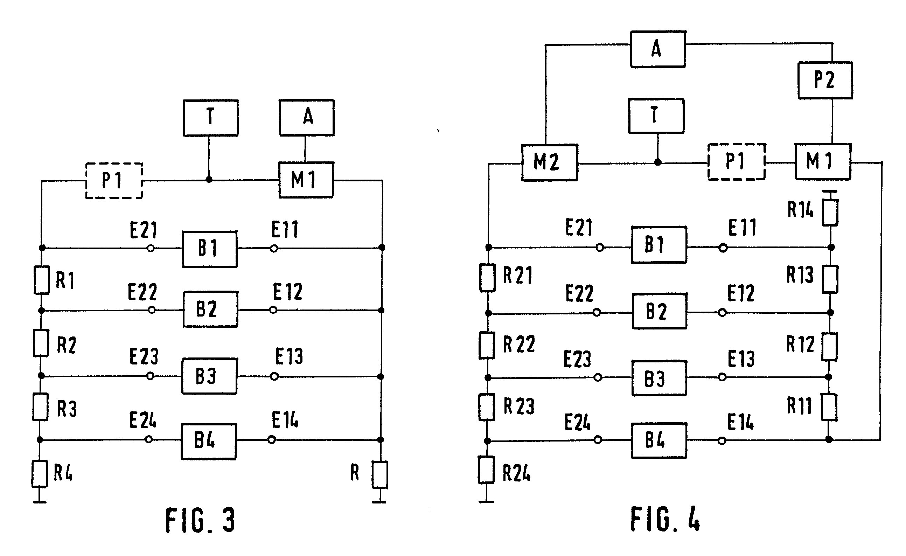

          Fig. 3 und 4 verwendbar ist;

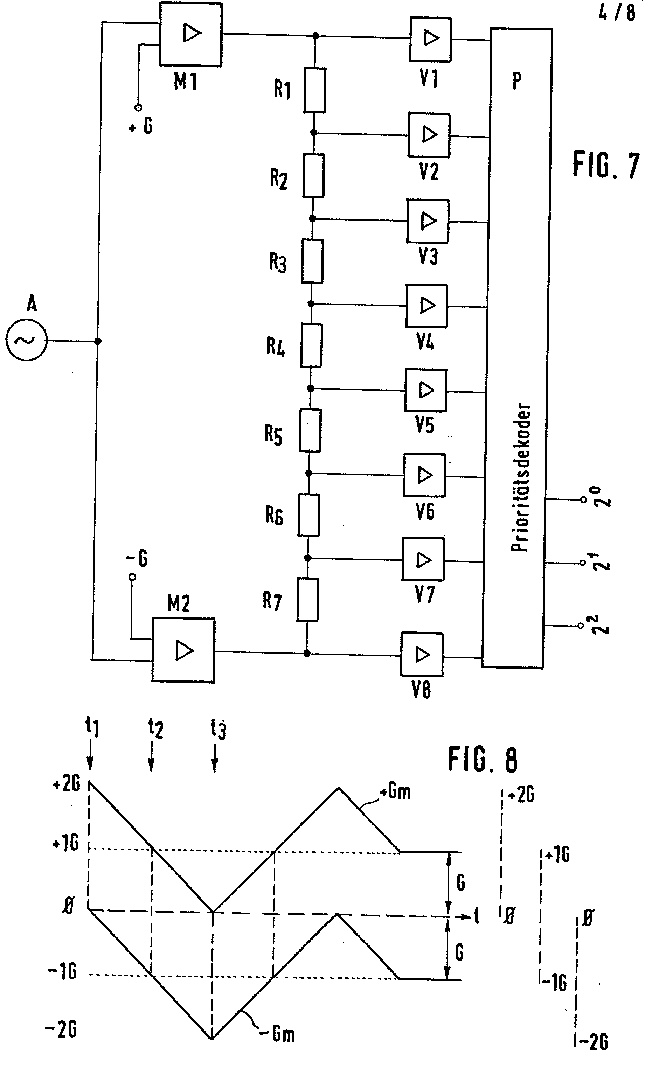

Fig. 6    eine zweite Ausführungsform einer Amplitudenvergleichsschaltung, die für die A/D-Wandler gemäß
          Fig. 3 und 4 verwendbar ist;

Fig. 7    eine vierte Ausführungsform eines erfindungsgemäßen A/D-Wandlers;

Fig. 8    eine graphische  Darstellung zur Erläuterung der
          Arbeitsweise des in Fig. 7 gezeigten A/D-Wandlers;

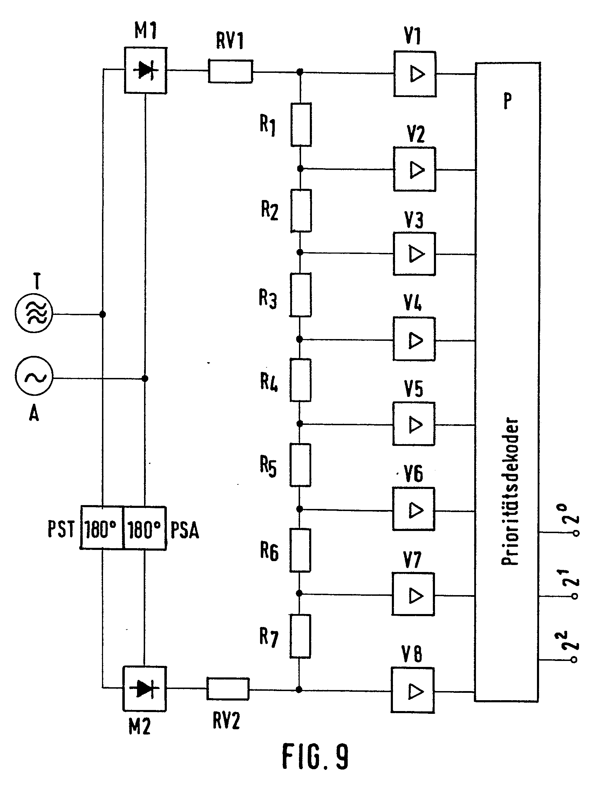

Fig. 9    eine fünfte Ausführungsform eines erfindungsgemäßen A/D-Wandlers;

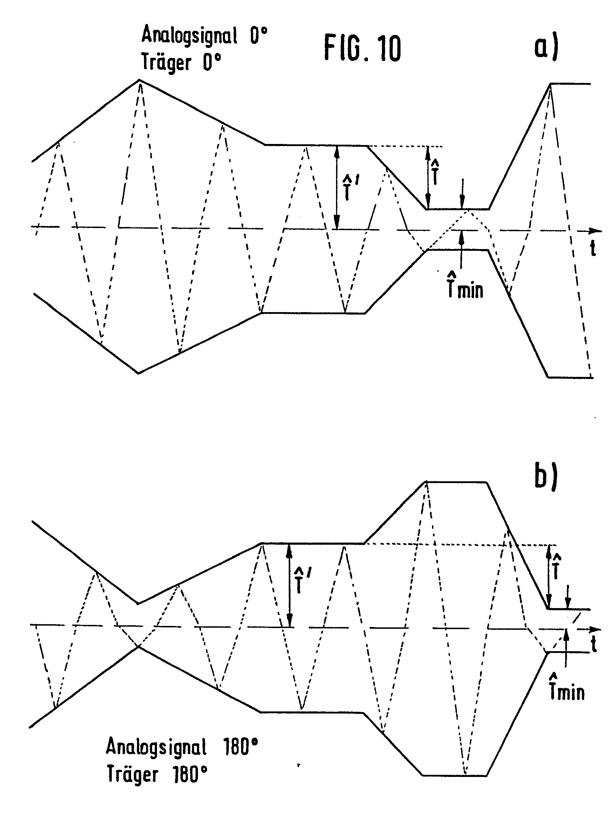

Fig. 10   eine Darstellung zur Erläuterung der Arbeitsweise des in Fig. 9 gezeigten A/D-Wandlers;

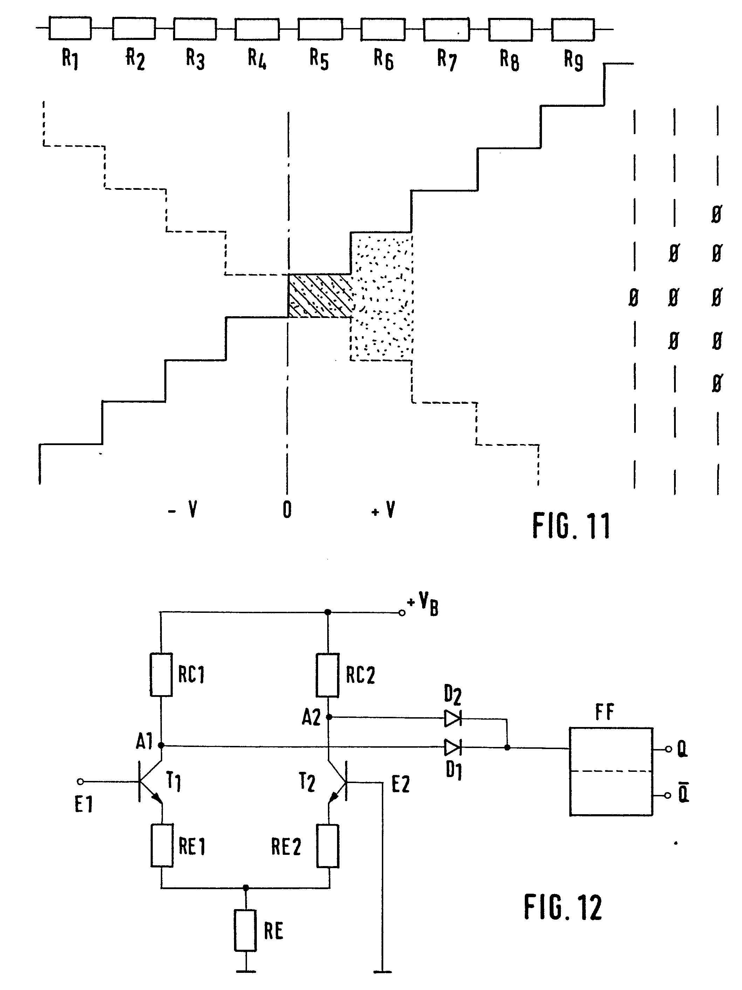

Fig. 11   eine Darstellung zur Erläuterung der Arbeitsweise einer modifizierten Form der in den Fig. 7
          und 9 gezeigten A/D-Wandler;

Fig. 12   einen Polaritätsinverter; und

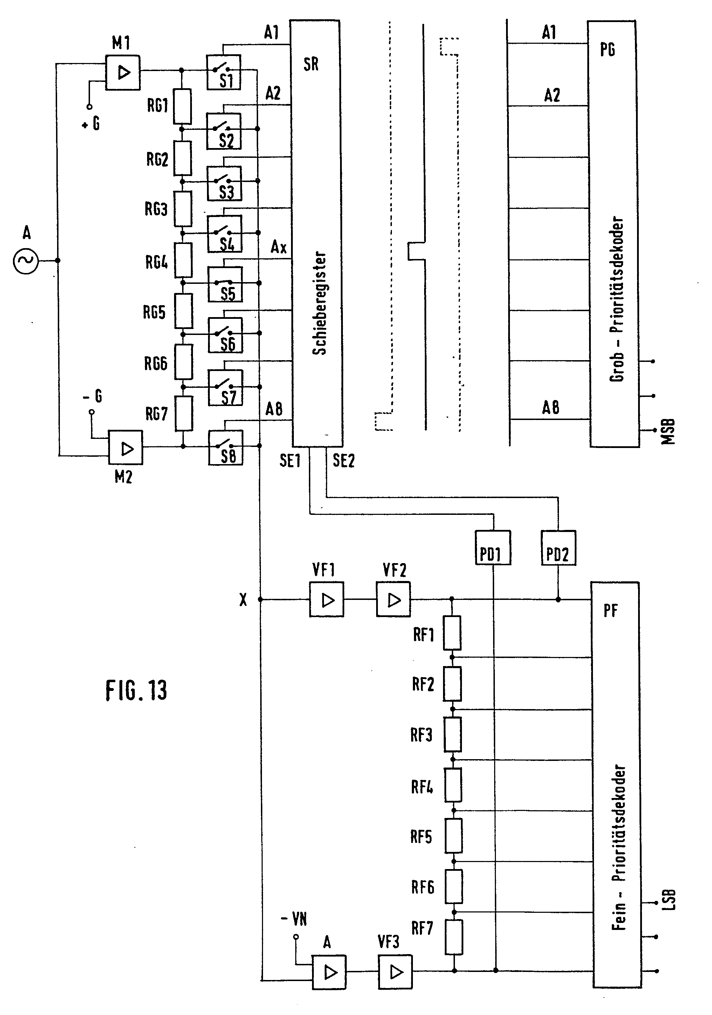

Fig. 13   eine sechste Ausführungsform eines erfindungsgemäßen A/D-Wandlers.

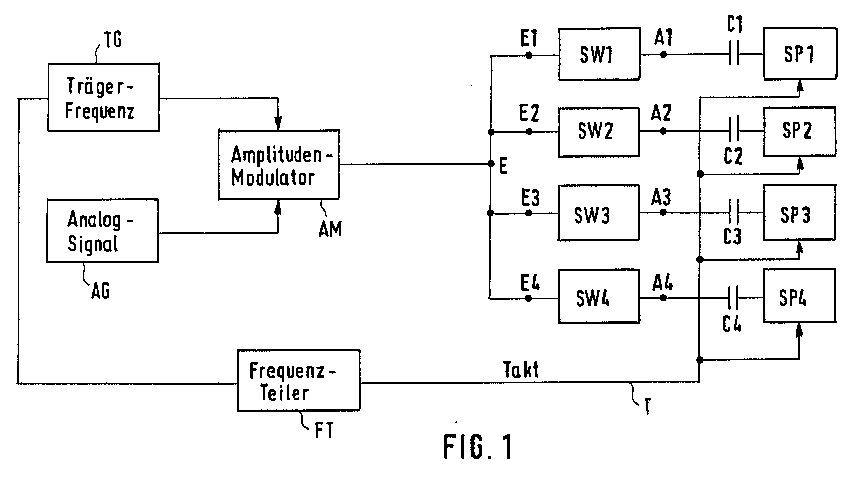

Bei der in Fig. 1 in Blockschaltbildform dargestellten Ausführungsform eines erfindungsgemäßen A/D-Wandlers wird einem Amplitudenmodulator AM einerseits von einem Trägerfrequenzgenerator TG eine Trägerfrequenz und andererseits von einer Analogsignalquelle AG das umzusetzende
Analogsignal zugeführt. Das am Ausgang des Amplitudenmodulators AM auftretende amplitudenmodulierte Signal
wird über einen Eingangsanschluß E auf die Eingänge E1
bis E4 von mehreren Schwellenwertschaltungen SW1 bis
SW4 gegeben. An deren Ausgänge A1 bis A4 sind je ein
Kondensator C1 bis C4 angeschlossen, mit denen wiederum
Speicher SP1 bis SP4 verbunden sind.

In der dargestellten Ausführungsform werden vier Schwellenwertschaltungen verwendet. Je nach gewünschter Quantisierungsauflösung des A/D-Wandlers kann auch eine andere
Anzahl von Schwellenwertschaltungen, insbesondere eine
größere Anzahl, verwendet werden. Die den Eingängen der
Speicher SP1 bis SP4 zugeführten Signale werden unter
Steuerung eines gemeinsamen Taktes T taktweise eingelesen. Hierfür kann ein unabhängiger Taktgenerator Verwendung finden. Bevorzugtermaßen wird die Taktfrequenz
aus der Trägerfrequenz abgeleitet, wofür erforderlichenfalls die Trägerfrequenz mit Hilfe eines Frequenzteilers
FT auf die gewünschte Taktfrequenz reduziert werden kann.

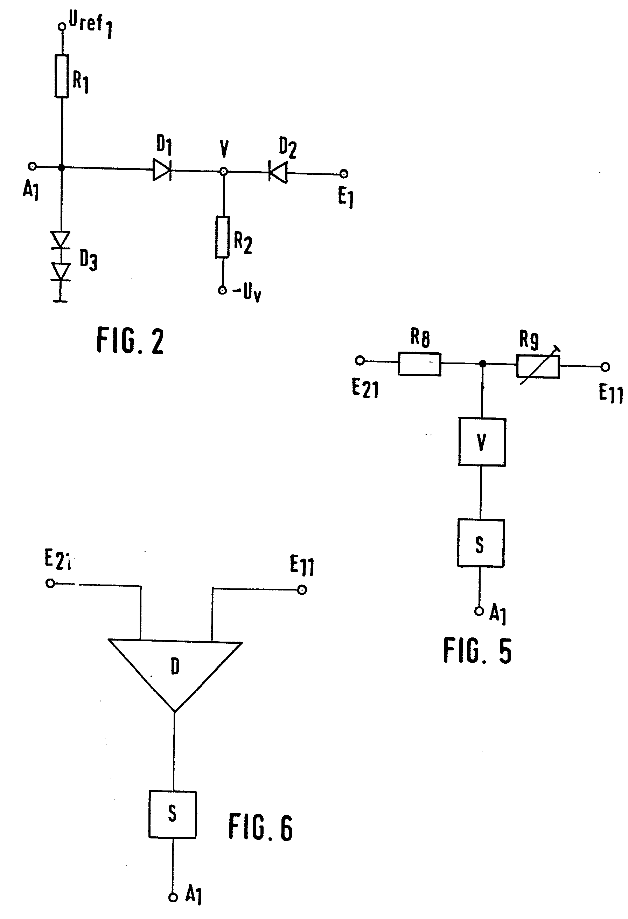

Fig. 2 zeigt eine bevorzugte Diodenschaltung für eine
Schwellenwertschaltung, beispielsweise SW1 in Fig. 1.
Zwischen den Eingang E1 und den Ausgang A1 sind zwei
gegensinnig hintereinander geschaltete Dioden D1 und D2
geschaltet, deren gemeinsamer Verbindungspunkt V über
einen Widerstand R2 an ein Potential $-U_v$ angeschlossen
ist, bei dem es sich vorzugsweise um Massepotential
handelt. Der Ausgangsanschluß A1 ist gleichzeitig der
Verbindungspunkt zwischen einem Widerstand R1 und einer
zwei Dioden aufweisenden Reihenschaltung D3. Das nicht mit dem Ausgang A1 verbundene Ende des Widerstandes R1
ist an eine Referenzspannungsquelle $U_{ref1}$ angeschlossen, während
das nicht mit A1 verbundene Ende der Diodenschaltung D3
mit einem Bezugspotential verbunden ist, vorzugsweise
ebenfalls Masse.

Die beiden Widerstände R1 und R2 stellen bei dieser Schaltung einfache Formen von Stromquellen dar, die jedoch auch
durch andere Formen von Stromquellenschaltungen ersetzt
werden können, beispielsweise Transistoren, Feldeffekt-
Stromquellen, Stromspiegelschaltungen und dergleichen. Die
Diodenschaltung D3 hat Spannungsbegrenzungsfunktion. Die
Anzahl der für D3 hintereinandergeschalteten Dioden hängt
von der jeweils erforderlichen Begrenzungsschwelle ab. Es
ist an dieser Stelle auch der Einsatz von Zener-Dioden
möglich.

Die in Fig. 2 gezeigte Schwellenwertschaltung arbeitet
folgendermaßen:

Zunächst sei angenommen, daß das am Eingang E1 anstehende,
umzusetzende Signal den Spannungswert Null aufweist. Dann fließt
ein Strom von $U_{ref1}$ über den Widerstand R1, die Diode D1 und
den Widerstand R2. Die Stärke dieses Stromes hängt von
$U_{ref1}$ und von den beiden Widerständen R1 und R2 ab. Bei
dem eingestellten Strom stellt sich am Schaltungspunkt V
ein bestimmtes Spannungspotential ein, das für den     mit
dem Analogsignal zu vergleichenden Schwellenwert bestimmend ist. Das Spannungspotential am Schaltungspunkt V
wird so gewählt, daß es um die Kniespannung der Diode D2
niedriger ist als der Schwellenwert, mit dem das Analogsignal verglichen werden soll.

Sobald das an E1 anliegende umzusetzende Signal den Schwellenwert dieser Schwellenwertschaltung überschreitet, wird die Diode D2 leitend, wodurch sich der Strom durch D1 verringert und damit die Spannung am Ausgang A1 in Richtung zum Spannungswert von $U_{ref1}$ zunimmt. Damit nun dabei die Spannung an A1 nicht zu groß wird, wird sie mit Hilfe von D3 begrenzt. Der Spannungswert, der sich an A1 einstellt, wenn das umzusetzende Signal an E1 unterhalb des Schwellenwertes liegt, wird als einer der beiden binären Logikwerte, beispielweise "0" definiert, während der sich beim Leiten der Diode D2 an A1 einstellende Spannungswert als der andere Logikwert, im Beispiel "1",definiert ist.

Für die verschiedenen Schwellenwertschaltungen SW1 bis SW4, deren Schwellenwerte unterschiedlich sind, werden entweder verschiedene Referenzspannungen $U_{ref1}$, $U_{ref2}$, ... und gleiche Werte für die Widerstände R1, R2 oder gleiche Referenzspannungen und unterschiedliche Werte für mindestens einen dieser beiden Widerstände R1 und R2 gewählt. Eine weitere Beeinflussungsmöglichkeit des Schwellenwertes ist durch Wahl unterschiedlicher Diodentypen mit verschiedenen Kniespannungen gegeben. Unterschiedliche Kniespannungen kann man auch durch unterschiedliche Anzahl hintereinandergeschalteter Dioden anstelle der Einzeldioden D1 und/oder D2 erreichen.

Fig. 3 zeigt eine zweite Ausführungsform eines erfindungsgemäßen A/D-Wandlers, bei der ein mit dem zu digitalisierenden Analogsignal amplitudenmoduliertes Trägerfrequenzsignal mit verschieden stark herabgestuften Amplitudenwerten des nicht-modulierten Trägerfrequenzsignals verglichen wird.

Einem Modulator M1 wird einerseits das von einer Trägerfrequenzquelle T kommende Trägerfrequenzsignal und andererseits das von einer Analogsignalquelle A kommende, zu
digitalisierende Analogsignal zugeführt. Am Ausgang des
Modulators M1 erscheint dann ein amplitudenmoduliertes
Trägerfrequenzsignal. Der Ausgang des Modulators M1 ist
einerseits über einen Widerstand R an Masse und andererseits an vier erste Eingänge E11, E12, E13, E14 von vier
Amplitudenvergleichsschaltungen B1, B2, B3 bzw. B4 angeschlossen. Die Trägerfrequenzquelle T ist außerdem über
einen Phasenschieber P1, der die Phasenlage des Trägerfrequenzsignals um 180° verschiebt, an den Eingang einer
Spannungsteiler-Widerstandskette mit vier Widerständen R1,
R2, R3 und R4 angeschlossen, die anderen Endes mit Masse
verbunden ist. Die jeweils dichter an der Trägerfrequenzquelle T liegenden Enden der Widerstände R1, R2, R3, R4
sind mit zweiten Eingangsanschlüssen E21, E22, E23 bzw.
E24 der Amplitudenvergleichsschaltungen B1, B2, B3 bzw.
B4 verbunden.

- 17 -

Der Phasenschieber P1 ist als gestrichelter Block dargestellt, da er nur wahlweise für den Fall vorgesehen wird,
daß das als Bezugssignal verwendete nicht-modulierte Trägerfrequenzsignal den Amplitudenvergleichsschaltungen B1
bis B4 mit einer Phasenlage, die derjenigen des modulierten
Trägerfrequenzsignals entgegengesetzt ist, zugeführt wird.

Die Widerstände R1 bis R4 weisen vorzugsweise gleiche Widerstandswerte auf, so daß von benachbarten Abgriffen dieser Widerstandskette abgreifbare Teilspannungen gleiche
Spannungsabstände voneinander aufweisen.

Während das nicht-modulierte Trägerfrequenzsignal konstante Amplitudenwerte aufweist, ändern sich die Amplitudenwerte des amplitudenmodulierten Trägerfrequenzsignals entsprechend dem modulierenden Analogsignal. Geht
man beispielsweise von einer Modulationstiefe von 50 %
und von einem sinusförmigen Analogsignal aus, ändert sich
z. B. die positive Amplitude des modulierten Trägerfrequenzsignals periodisch zwischen 50 % und 150 % des Wertes
der positiven Amplituden des nicht-modulierten Trägerfrequenzsignals. Wenn man nun die in Fig. 3 gezeigte
Schaltung derart auslegt, daß der an den ersten Eingängen
E11 bis E14 bei maximalem Amplitudenwert des modulierten
Trägerfrequenzsignals auftretende Spannungswert gleich
groß ist wie der am zweiten Eingang E21 auftretende
Amplitudenwert des nicht-modulierten Trägerfrequenzsignals, wird bei dem Vorliegen einer solchen maximalen Amplitude des modulierten Trägerfrequenzsignals zwischen den beiden Eingängen E11 und E21 der obersten Amplitudenvergleichsschaltung Spannungsgleichheit festgestellt, ansonsten zwischen den Eingängen einer der darunterliegenden Amplitudenvergleichsschaltungen B2 bis B4. Wenn man nun dem Ausgangssignal derjenigen Amplitudenvergleichsschaltung, die gleiche Spannungen an ihren beiden Eingängen feststellt, den binären Logikwert "0" und den Ausgangssignalen aller anderen Amplitudenvergleichsschaltungen den binären Logikwert "1" zuordnet, erhält man einen Binärcode, bei dem die Lage des einzigen Logikwerts "0" den digitalisierten Momentanwert des Analogsignals kennzeichnet.

In den Fig. 3 und 4 sind Ausführungsformen mit nur vier Amplitudenvergleichsschaltungen dargestellt. In Wirklichkeit wird man selbstverständlich eine wesentlich größere Anzahl von Amplitudenvergleichsschaltungen verwenden, um eine wesentlich feinere Digitalisierungsauflösung zu erreichen als sie mit nur vier Amplitudenvergleichsstufen erzielt werden kann. Die Anzahl der Widerstände in den Spannungsteiler-Widerstandsketten erhöht sich dann um die entsprechende Zahl, um entsprechend viele Teilspannungen zur Verfügung stellen zu können, die dann natürlich auch kleinere Spannungsabstände als bei nur vier Amplitudenvergleichsstufen aufweisen.

Bei der folgenden Betrachtung der Funktionsweise der in Fig. 3 dargestellten Ausführungsform wird zunächst die Variante betrachtet, daß das modulierte und das nicht-modulierte Trägerfrequenzsignal mit gleicher Phasenlage verwendet werden, daß also der Phasenschieber P1 nicht vorhanden, sondern die Trägerfrequenzquelle T direkt mit dem Eingang der Widerstandskette R1 bis R4 verbunden ist. Je nach Momentanwert des amplitudenmodulierenden Analogsig-

nals tritt dann an den beiden Eingängen irgendeiner der
Amplitudenvergleichsschaltungen Amplitudengleichheit zwischen dem dem ersten Eingang dieser Amplitudenvergleichsschaltung zugeführten modulierten Trägerfrequenzsignal
und dem dem zweiten Eingang dieser Amplitudenvergleichsschaltung zugeführten Teilspannungswert des nicht-modulierten Trägerfrequenzsignals auf. Dieser Gleichheit zwischen den Amplitudenwerten an den beiden Eingängen dieser
Amplitudenvergleichsschaltung wird der Logikwert "0" zugeordnet. Zwischen den Amplitudenwerten, die den beiden
Eingängen der übrigen Amplitudenvergleichsschaltungen zugeführt werden, besteht Ungleichheit, welcher der Logikwert "1" zugeordnet wird. Selbstverständlich kann man auch
die umgekehrte Zuordnung dieser Logikwerte vornehmen.

Führt man dagegen das amplitudenmodulierte Trägerfrequenzsignal und das nicht-modulierte Trägerfrequenzsignal den
einzelnen Amplitudenvergleichsschaltungen mit entgegengesetzter Phase zu, fügt man also den in Fig. 1 gestrichelt
gezeichneten Phasenschieber P1 zwischen der Trägerfrequenzquelle T und dem Eingang der Widerstandskette R1 bis
R4 ein, kommt es bei einem bestimmten Momentanwert des modulierenden Analogsignals an irgendeiner der Amplitudenvergleichsschaltungen B1 bis B4 zu einer Auslöschung zwischen den an ihren beiden Eingängen auftretenden Amplituden von moduliertem Trägerfrequenzsignal und nicht-moduliertem Trägerfrequenzsignal. In diesem Fall kann man der
Auslöschung den Logikwert "0" und der Nicht-Auslöschung
den Logikwert "1" zuordnen  oder umgekehrt.

Die Fig. 5 und 6 zeigen bevorzugte Ausführungsformen für
die Amplitudenvergleichsschaltungen B1 bis B4, wobei die
Ausführungsform in Fig. 3 für den Betrieb mit entgegengesetzter Phasenlage von moduliertem und nicht-moduliertem Trägerfrequenzsignal und die Ausführungsform nach
Fig. 4 für den Betrieb mit gleicher Phasenlage von moduliertem und nicht-moduliertem Trägerfrequenzsignal verwendbar ist. In den Fig. 5 und 6 ist als Beispiel jeweils die oberste Amplitudenvergleichsschaltung B1 betrachtet.

Die in Fig. 5 gezeigte Ausführungsform für den Betrieb mit entgegengesetzter Phasenlage weist zwischen dem ersten Eingang E11 und dem zweiten Eingang E21 eine Reihenschaltung aus zwei Widerständen R8 und R9 auf, wobei R9 für Symmetrierungszwecke als veränderbarer Widerstand ausgebildet sein kann. An den Verbindungspunkt zwischen R8 und R9 ist ein Verstärker V angeschlossen, dem eine Schwellenwertschaltung S nachgeordnet ist. Deren Ausgang bildet den Ausgang A1 der Amplitudenvergleichsschaltung. Tritt an der betrachteten Amplitudenvergleichsschaltung Auslöschung zwischen den beiden ihren Eingängen zugeführten Amplituden auf, tritt am Ausgang des Verstärkers V ein Ausgangssignal Null auf. Besteht keine Auslöschung an der betrachteten Amplitudenvergleichsschaltung, entsteht am Ausgang des Verstärkers V ein von Null verschiedenes Ausgangssignal. Da nun aber aufgrund der Quantisierungstufen dann, wenn der Momentanwert des Analogsignals zwischen zwei benachbarten Quantisierungsstufen liegt, an keinem Verstärkerausgang ein exakter Signalwert Null auftritt, ist die Schwellenwertschaltung S vorgesehen, mittels welcher von Null verschiedene Spannungswerte unterhalb einer vorgegebenen Schwelle noch dem Logikwert "0" zugeordnet werden.

Die Schwellenwertschaltung braucht keine gesonderte Schaltung zu sein, wenn man für V einen Verstärker mit Schwellenwertverhalten verwendet.

Die in Fig. 6 gezeigte Amplitudenvergleichsschaltung für Betrieb mit gleicher Phasenlage von moduliertem und nicht-moduliertem Trägerfrequenzsignal besteht aus einem Differenzverstärker D, dessen beide Eingänge den ersten Eingang E11 bzw. den zweiten Eingang E21 der Amplitudenvergleichsschaltung bilden. An den Ausgang des Differenzverstärkers D ist wieder eine Schwellenwertschaltung S angeschlossen, deren Ausgang ebenfalls den Ausgang A1 der Amplitudenvergleichsschaltung bildet. Die Verwendung eines
Differenzverstärkers D führt zu einer guten Gleichtaktunterdrückung von eventuell vorhandenen Gleichspannungsanteilen.

Wenn man die Schwellen der Schwellenwertschaltungen S in
den Fig. 5 und 6 entsprechend hochlegt, kann man erreichen, daß bei Auslöschung im Betrieb mit entgegengesetzter
Phasenlage bzw. bei Amplitudengleichheit beim Betrieb mit
gleicher Phasenlage, die sich am Ausgang des Differenzverstärkers D als quasi-Auslöschung auswirkt, nicht nur am
Ausgang einer einzigen Amplitudenvergleichsschaltung, sondern am Ausgang zweier oder auch mehrerer benachbarter Amplitudenvergleichsschaltungen der diesem Zustand zugeordnete Logikwert, beispielsweise "0",auftritt. Durch die Lage
der mehreren Logikwerte "0" innerhalb des Binärwertmusters
kann man dann auf den digitalisierten Momentanwert des Analogsignals schließen.

Die in Fig. 4 gezeigte dritte Ausführungsform des erfindungsgemäßen A/D-Wandlers unterscheidet sich von der in
Fig. 3 gezeigten Ausführungsform im wesentlichen darin,
daß auch das Bezugssignal mit dem zu digitalisierenden Analogsignal amplitudenmoduliert ist. Zu diesem Zweck weist
die in Fig. 4 gezeigte Ausführungsform zusätzlich zu den
Komponenten der Ausführungsform nach Fig. 3 einen zweiten
Modulator M2, einen zweiten Phasenschieber P2 und eine
zweite Spannungsteiler-Widerstandskette R11, R12, R13, R14
auf. Die Widerstände R21, R22, R23, R24 der in Fig. 4 linken Spannungsteiler-Widerstandskette stimmen mit den Widerständen R1, R2, R3 bzw. R4 der Spannungsteiler-Widerstandskette in Fig. 3 überein.

Das Analogsignal von der Analogsignalquelle wird dem einen Modulator, beispielsweise und wie in Fig. 4 gezeigt, dem ersten Modulator M1, über den zweiten Phasenschieber P2 zugeführt, der die Phasenlage des Analogsignals um 180° verschiebt. Dem zweiten Modulator M2 wird das Analogsignal direkt zugeführt. Wie bei der ersten Ausführungsform der Fig. 3 kann man die beiden amplitudenmodulierten Trägerfrequenzsignale in gleicher oder entgegengesetzter Phasenlage verwenden, wozu man den gestrichelt gezeichneten Phasenschieber P1 wegläßt bzw. einfügt, wobei es gleichwirkend ist, ob der Phasenschieber P1 dem ersten Modulator M1 oder dem zweiten Modulator M2 vorgeschaltet wird, genauso wie es gleichwirkend ist, ob der zweite Phasenschieber P2 dem ersten Modulator M1 oder dem zweiten Modulator M2 vorgeschaltet wird.

Wie in Fig. 4 dargestellt ist, sind die ersten Eingänge E11 bis E14 der Amplitudenvergleichsschaltungen B1 bis B4 in einer Reihenfolge an die Widerstandskette R11 bis R14 angeschlossen, die entgegengesetzt zu derjenigen Reihenfolge ist, in welcher die zweiten Eingänge E21 bis E24 der Amplitudenvergleichsschaltungen B1 bis B4 an die Widerstandskette R21 bis R24 angeschlossen sind. Das heißt, der erste Eingang E11 der obersten Amplitudenvergleichsschaltung B1 ist an den niedrigsten Teilspannungswert des vom ersten Modulator M1 kommenden amplitudenmodulierten Trägerfrequenzsignals angeschlossen, während der zweite Eingang E21 dieser Amplitudenvergleichsschaltung B1 an den höchsten Teilspannungswert des vom zweiten Modulator M2 kommenden modulierten Trägerfrequenzsignals angeschlossen ist. Der erste Eingang E12 der zweiten Amplitudenvergleichsschaltung B2 ist an den zweitniedrigsten Teilspannungswert der Widerstandskette R11 bis R14 angeschlossen, während der zweite Eingang E22 dieser Amplitudenvergleichsschaltung B2 an den zweithöchsten Teilspannungswert der Widerstandskette R21 bis R24 angeschlossen ist; usw.

Wie im Fall der Fig. 3 erreicht man bei gleichphasiger Zuführung der beiden modulierten Trägerfrequenzsignale Amplitudengleichheit an den beiden Eingängen einer der Amplitudenvergleichsschaltungen, während man bei Betrieb mit entgegengesetzter Phasenlage der beiden amplitudenmodulierten Trägerfrequenzsignale Auslöschung an einer der Amplitudenvergleichsschaltungen erzielt. Aufgrund der Verwendung zweier amplitudenmodulierter Trägerfrequenzsignale, die mit entgegengesetzter Phasenlage amplitudenmoduliert sind, erreicht man bei dieser Ausführungsform eine doppelt so hohe Digitalisierungsempfindlichkeit wie bei der Ausführungsform nach Fig. 3. Das heißt, bei der Ausführungsform nach Fig. 4 wird diejenige Stufe, an welcher Amplitudengleichheit bzw. Auslöschung auftritt, viel schärfer definiert als bei der Ausführungsform nach Fig. 3. Bei entsprechend hoher Anzahl von Amplitudenvergleichsschaltungen kann man daher eine Digitalisierungsauflösung erreichen, die doppelt so hoch ist wie bei der Ausführungsform nach Fig. 3.

Der erfindungsgemäße A/D-Wandler benötigt im Gegensatz zu herkömmlichen A/D-Wandlern keine Komparatoren, die im Sättigungsbereich arbeitende Transistoren aufweisen und daher verzögerungsbehaftet sind. Vielmehr kommt der erfindungsgemäße A/D-Wandler mit praktisch verzögerungsfreien Verstärkern oder Differenzverstärkern aus. Er ist daher für Frequenzen bis in den GHz-Bereich geeignet. Durch Ausnutzung der Auslöschung bzw. quasi-Auslöschung kommt es zu einer scharfen Digitalbewertung, die eine hohe Digitalisierungsauflösung ermöglicht. Durch das Arbeiten bei einer festen Trägerfrequenz ist man von Frequenzgangeinflüssen und -verfälschungen frei. Außerdem können die Schaltungskomponenten aufgrund der Benutzung einer konstanten Trägerfrequenz und einer vorgegebenen Modulationstiefe praktisch mit konstanter Leistung betrieben werden, so daß auch Verfälschungen aufgrund leistungsabhängigen Verhal-

tens einzelner Schaltungskomponenten nicht auftreten können. Der erfindungsgemäße A/D-Wandler weist daher neben
seiner Hochfrequenztauglichkeit auch eine sehr hohe Digitalisierungsgenauigkeit auf.

Wie bereits erwähnt worden ist, kann man die Trägerfrequenz bis auf Null absenken, d. h., eine Gleichspannung
mit dem Analogsignal modulieren. Auch hierbei kommt es
im Bereich einer der Bewertungs- bzw. Amplitudenvergleichsstufen zu einer Auslöschung oder Quasi-Auslöschung.

Die Figuren 7 und 9 zeigen eine vierte bzw. fünfte Ausführungsform des erfindungsgemäßen A/D-Wandlers. Während
dem A/D-Wandler in Fig. 9 ein Trägerfrequenzsignal mit
einer von Null verschiedenen Frequenz zugeführt wird,
zeigt Fig. 7 den Sonderfall eines A/D-Wandlers, bei dem
der Träger die Frequenz Null aufweist, d.h., bei dem Gleichspannungen amplitudenmoduliert werden.

Als erstes wird der in Fig. 7 betrachtete Sonderfall mit
der Amplitudenmodulation von Gleichspannungsträgern betrachtet.

Dieser A/D-Wandler weist zwei Gleichspannungsmodulatoren
M1 und M2 auf, die je mit dem zu digitalisierenden Analogsignal A gespeist werden und denen Gleichspannungen + G
bzw. -G gleichen Betrages aber verschiedener Polarität
zugeführt werden. Zwischen die Ausgänge der beiden Modulatoren M1 und M2 ist eine Widerstandskette mit Widerständen R1 bis R7 geschaltet. An die einzelnen Spannungsteilerpunkte dieser Widerstandskette R1 bis R7 sind Verstärker V1 bis V8 angeschlossen, deren Ausgänge mit den
Eingängen eines Prioritätsdecoders P verbunden sind.

Jeder der Verstärker V1 bis V8 hat die Funktion eines Null-Detektors. Einem Verstärker mit Ausgangsspannung Null wird ein erster Binärwert beispielsweise "0", zugeordnet, während einem Verstärker mit einem von Null verschiedenen Ausgangssignal der entgegengesetzte Binärwert, z. B. "1" zugeordnet wird. Die Verstärker V1 bis V8 können mit einem Schwellenverhalten ausgebildet sein, so daß auch Spannungswerten, die zwischen Null und dem Schwellenwert liegen, der erste Binärwert "0" zugeordnet wird.

Es wird nun die Arbeitsweise dieses A/D-Wandlers unter Zuhilfenahme von Figur 8 betrachtet.

Bei fehlendem Analogsignal gibt der Ausgang des Modulators M1 eine konstante positive Gleichspannung +G an das obere Ende der Widerstandskette, während der Modulator M2 eine negative konstante Gleichspannung -G an das untere Ende der Widerstandskette gibt. Daher kommt es in der Mitte der Widerstandskette zu einer Spannungsauslöschung oder Spannungsaufhebung. In der Mitte der Widerstandskette tritt daher der Spannungswert Null auf. An den oberhalb der Mitte liegenden Spannungsteilerpunkten treten positive Spannungen auf, während an den unterhalb der Mitte liegenden Spannungsteilerpunkten negative Spannungswerte erscheinen.

Weist das Analogsignal A einen zeitlichen Verlauf auf, wie er in Fig. 8 gezeigt ist, gibt der Modulator M1 eine entsprechend modulierte positive Gleichspannung +Gm an das obere Ende der Widerstandskette,während der Modulator M2 eine modulierte negative Gleichspannung -Gm an das untere Ende der Widerstandskette gibt. Wie Fig. 8 zeigt, bleibt die Spannung zwischen den beiden Enden der Widerstandskette immer gleich, nämlich 2G. Es verschiebt sich aber derjenige Spannungsteilerpunkt, an dem der Spannungswert
Null und damit der Binärwert "0" auftritt. Als Beispiel
werden die zu den drei verschiedenen Zeitpunkten t1, t2
und t3 auftretenden Spannungsverhältnisse betrachtet. Zum
Zeitpunkt t1 weist das Analogsignal A einen Spannungswert
+G auf, so daß am oberen Ende der Widerstandskette ein
Spannungswert +2G und am unteren Ende der Widerstandskette der Spannungswert 0 auftritt. Somit erscheint am
untersten Verstärker V8 der Spannungswert 0 und damit der
Binärwert "0", während an den Verstärkern V1 bis V7 die
Binärwerte "1" auftreten. Zum Zeitpunkt t2 ist das Analogsignal Null, so daß am oberen und am unteren Ende
der Widerstandskette die Spannungswerte +G bzw. -G auftreten. Daher treten der Spannungswert Null und der Binärwert "0" in der Mitte der Widerstandskette auf. Zum Zeitpunkt t3 weist das Analogsignal den Spannungswert -G auf,
so daß am oberen und am unteren Ende der Widerstandskette
die Spannungswerte Null bzw. -2G erscheinen. Somit treten
der Spannungswert Null und der Binärwert "0" am obersten
Verstärker V1 auf.

Als Folge davon, daß dem Analogsignal in den Modulatoren
M1 und M2 Gleichspannungen gleichen Betrages aber entgegengesetzten Vorzeichens überlagert werden, erreicht
man, daß der Spannungsauslöschungspunkt immer irgendwo
an der Widerstandskette auftritt, wenn man nur dafür
sorgt, daß der Betrag der Gleichspannung G mindestens
so groß wie die maximale Amplitude des Analogsignals
ist. Durch das erfindungsgemäße Verfahren hat man somit
erreicht, daß bei jedem Wert des Analogsignals der
Spannungsauslöschungspunkt immer in dem "Meßfenster" zu liegen kommt, das die Widerstandskette bildet.

Bei der in Fig. 9 gezeigten Ausführungsform wird den
beiden Modulatoren M1 und M2 je ein Trägerfrequenzsignal
T und das zu digitalisierende Analogsignal A zugeführt,
wobei das Trägerfrequenzsignal T und das Analogsignal A
dem oberen Modulator M1 je direkt und dem unteren Modulator M2 je nach einer Phasenverschiebung um 180 °
zugeführt werden. Zwischen die Ausgänge der Modulatoren
M1 und M2 und die Enden der Widerstandskette R1 bis R7
sind Dämpfungswiderstände RV1 bzw. RV2 geschaltet. Ansonsten
stimmt die in Fig. 9 gezeigte Ausführungsform mit der in
Fig. 7 gezeigten Ausführungsform überein.

Die Arbeitsweise dieses A/D-Wandlers wird nun unter Zuhilfenahme von Fig. 10 betrachtet. Die Figuren 10a und
10b zeigen die in den Modulatoren M1 bzw. M2 erzeugten
amplitudenmodulierten Trägerfrequenzsignale. Der üblichen
Praxis entsprechend wird von einem Modulationsgrad ausgegangen, der kleiner als Eins ist. D.h., der Amplitudenhub $\hat{T}$ ist kleiner als die Amplitude $\hat{T}'$ des unmodulierten
Trägers. Die Hüllkurve  weist daher immer eine Mindestamplitude $\hat{T}min$ auf.

Die Dämpfungswiderstände RV1 und RV2 sind nun so bemessen,
daß sie eine $\hat{T}min$ entsprechende Spannungsabsenkung bewirken.

Für ein leichteres Verständnis der Funktionweise des in
Fig. 9 gezeigten A/D-Wandlers kann man nun folgende Hilfsüberlegung anstellen. Wenn man in Fig. 8, die für den
gleichspannungsmodulierenden A/D-Wandler gilt , den Betrag der an die Modulatoren M1 und M2 angelegten Gleichspannung G ändert, rücken zwar die beiden modulierten

Gleichspannungen +Gm und -Gm näher zusammen oder weiter
auseinander. Die Mittellinie zwischen diesen beiden modulierten Gleichspannungen ändert sich  dabei aber nicht.
D.h., derjenige Punkt der Widerstandskette, an dem aufgrund der Auslöschung der Spannungswert Null erscheint,
bleibt unverändert. An den restlichen Punkten der Widerstandskette ändert sich dabei allerdings der jeweils
auftretende Spannungswert.

Im Fall der amplitudenmodulierten beiden Träger, wie sie
in Fig. 10 gezeigt sind, kann man sich nun vorstellen,
daß die Nullstellen der Trägerfrequenz demjenigen Fall
in Fig. 8 entsprechen, in welchem der Betrag der Gleichspannung G Null ist, während den Amplitudenspitzen der
Trägerfrequenzsignale maximale Beträge der Gleichspannung G entsprechen. D.h., bei der in Fig. 8 gezeigten
Darstellung verändert sich der vertikale Abstand zwischen
den beiden Kurven +Gm und -Gm laufend entsprechend dem
jeweiligen Momentanwert der Trägerspannung.  Die für
den Auslöschungspunkt auf der Widerstandskette bestimmende Mittellinie zwischen +Gm und -Gm bleibt jedoch
immer gleich.

Bei einem bestimmten Analogsignalwert tritt daher am Ausgang eines der Verstärker V1 bis V8 in Fig. 9 solange
ein Spannungswert Null auf, wie dieser Analogsignalwert
sich nicht ändert. An den Ausgängen der restlichen Verstärker erscheinen Schwingungen mit der Trägerfrequenz,
deren Spitzenwerte um so größer werden, je weiter der
jeweils betrachtete Verstärker von dem die Nullspannung
aufweisenden Verstärker entfernt liegt. Die an den Verstärkern unterhalb des die Nullspannung aufweisenden Verstärkers auftretenden Wechselspannungen weisen eine Phasenlage auf, die entgegengesetzt ist zu der Phasenlage derjenigen Wechselspannungen, die an den Verstärkern oberhalb des die Nullspannung aufweisenden Verstärkers erscheinen.

Wenn man nun beispielsweise mit den positiven Halbwellen
dieser Wechselspannungen Flipflops setzt, die im Prioritätsdecoder P enthalten oder dessen Eingängen vorgeschaltet sind, erhält man ein Logikwertmuster, das an der
Stelle des die Nullspannung aufweisenden Verstärkers
beispielsweise den Binärwert "0" und an den Ausgängen
der restlichen Verstärker den Binärwert "1" zeigt. Der
Prioritätsdecoder P stellt nun beispielsweise fest, wo,
vom obersten Spannungsteilerpunkt der Widerstandskette
beginnend, das erstemal  der Binärwert "0" erscheint. Der
Prioritätsdecoder P gibt dann an seinen Ausgängen ein
dualcodiertes Binärwertmuster ab, das vom Ort des Auftretens der Spannungsauslöschung auf der Widerstandskette
abhängt und somit vom umgesetzten Analogsignalwert.

Bei dem in Fig. 7 gezeigten A/D-Wandler müssen die Verstärker V1 bis V8 einen Frequenzbereich von Null bis zur
Maximalfrequenz des Analogsignals verarbeiten können.
Möchte man das Erfordernis von Verstärkern, die bis herab
zu Gleichspannung verstärken können, vermeiden, ist die
Ausführungsform nach Fig.9 zu bevorzugen, deren Verstärker V1 bis V8 lediglich die Trägerfrequenz (z. B. 100
MHz zu verstärken brauchen, mit einer Bandbreite gleich
der doppelten maximalen Analogsignalfrequenz (z. B. 20 MHz).

In Fig. 12 ist eine bevorzugte Ausführungsform für die Verstärker V1 bis V8 dargestellt. Dabei handelt es sich um
einen Differenzverstärker mit Transistoren T1 und T2, deren
Emitter über Emitterwiderstände RE1 bzw. RE2 an einen

0155702

anderen Endes an Masse gelegten Widerstand RE angeschlossen sind. Die Kollektoren der beiden Transistoren T1 und T2 sind über Kollektorwiderstände RC1 bzw. RC2 an eine Spannungsquelle +V$_B$ angeschlossen. Die Kollektoren von T1 und T2 sind über Dioden D1 bzw. D2 an einen Setz-Eingang eines Flipflop FF angeschlossen. Die Basis von T1 bildet den mit der Widerstandskette verbundenen Eingang E1 des Differenzverstärkers. Die einen zweiten Eingang E2 bildende Basis von T2 ist an Masse angeschlossen.

Dieser Differenzverstärker wirkt als Polaritätsinverter, der an E1 auftretende Eingangsspannungen beliebiger Polarität in Ausgangsspannungen nur einer einzigen Polarität umwandelt. Wenn man den in Fig. 12 gezeigten Differenzverstärker für die Verstärker V1 bis V8 des in Fig. 7 gezeigten A/D-Wandlers einsetzt, erhält man an allen Verstärkern, an denen keine Spannungsauslöschung auftritt, ein Ausgangssgignal gleicher Polarität, so daß man mit einer Zweipegel-Logik weiter arbeiten kann.

Die Wirkung dieser Maßnahme kann man sich anhand von Fig.11 veranschaulichen. Dort wird der Fall einer Widerstandskette mit neun Widerständen R1 bis R9 betrachtet und angenommen, daß die Spannungsauslöschung und damit der Nullspannungswert zwischen den Widerständen R4 und R5 auftritt. Nimmt man an, daß rechts von der strichpunktierten Linie, welche die Spannung Null darstellt, positive Teilerspannungen und links von dieser strichpunktierten Linie negative Teilerspannungen auftreten, ergeben sich für den durchgezogenen Stufenspannungsverlauf an den Widerständen R5 bis R9 positive und an den Widerständen R1 bis R4 negative Spannungen. Mit Hilfe des in Fig. 12 gezeigten Polaritätsinverters wird der im negativen Spannungsbereich liegende Treppenteil in den positiven Spannungsbereich geklappt, entsprechend der gestrichelt dargestellten
Stufenspannung rechts von der strichpunktierten Null-
Linie. Dieses umgeklappte Spannungsmuster kann man mit
einer Zweipegel-Logik verarbeiten.

In Fig. 11 sind rechts neben den Treppenspannungen drei
Binärwertmuster angegeben. Sie gelten für eine unterschiedlich hohe spannungsmäßige Entscheidungsschwelle zwischen
den Logikwerten "0" und "1". D.h., setzt man die Spannungsschwelle, oberhalb welcher der Logikwert "1" zugeordnet
wird, sehr niedrig an, erhält man ein Binärwertmuster,
das lediglich eine einzige "0" und ansonsten nur die Binärwerte "1" enthält. Mit zunehmender Anhebung dieser Entscheidungsschwelle wird die Anzahl der Binärwerte "0"
zwischen den Binärwerten "1" immer größer. Die mittlere
"0" bleibt jedoch für den in Fig. 11 angenommenen Analogsignalwert immer an der gleichen Stelle. Und diese Stelle
kennzeichnet den Analogsignalwert.

Der in Fig. 12 gezeigte Differenzverstärker kann auch für
die Amplitudenmodulatoren M1 und M2 eingesetzt werden. Im
Fall des in Fig. 7 gezeigten A/D-Wandlers wird beispielsweise dem Eingang E1 das zu digitalisierende Analogsignal
und dem Eingang E2 die Gleichspannung +G bzw. -G zugeführt.
Im Fall des in Fig. 9 gezeigten A/D-Wandlers kann man einem
der beiden Eingänge E1 und E2 das Analogsignal und dem
anderen dieser beiden Eingänge das Trägerfrequenzsignal
zuführen. Insbesondere bei hohen Trägerfrequenzen wird
allerdings ein Diodenmodulator zu bevorzugen sein.

Bei den in Figuren 7 und 9 gezeigten A/D-Wandlern kann man
eine hohe Digitalisierungsauflösung durch eine Widerstandskette mit entsprechend vielen Widerständen realisieren.

Eine Ausführungsform, bei welcher man eine hohe Digitalisierungsauflösung mit relativ wenigen Widerständen erreichen kann, ist in Fig. 13 gezeigt. Ein Grobwandlerteil mit Amplitudenmodulatoren M1 und M2 und mit einer Grobteilerkette RG1 bis RG7 stimmt mit dem in Fig. 7 gezeigten
A/D-Wandler überein, mit der Ausnahme, daß an die einzelnen
Spannungsteilerpunkte nicht Verstärker sondern Schalter
S1 bis S8 angeschlossen sind. Diese Schalter S1 bis S8 sind
anderen Endes in einem Verbindungspunkt X zusammengeschaltet.
Die Schalter S1 bis S8 weisen Steueranschlüsse A1 bis A8
auf, die je an einen Ausgang eines Schieberegisters SR und
an einen Eingang eines Prioritätsdecoders PG angeschlossen
sind.

Zusätzlich ist eine Feinteilerkette RF1 bis RF7 vorgesehen, die einen Endes über zwei in Reihe geschaltete Verstärker VF1 und VF2 und anderen Endes über eine Reihenschaltung aus einem Addierer A und einem Verstärker VF3
an den Verbindungspunkt X angeschlossen ist. In dem
Addierer A wird der am Verbindungspunkt X erscheinenden
Spannung eine negative Gleichspannung -VN überlagert,
deren Betrag gleich dem n-ten Teil der über der Grobteilerkette RG1 bis RG7 liegenden Spannung ist, also 2·G/n.
Dabei        ist n die Anzahl der Widerstände der Grobteilerkette, die alle gleichen Widerstandswert aufweisen.

Die Spannungsteilerpunkte der Feinteilerkette RF1 bis
RF7 sind an die Eingänge eines Fein-Prioritätsdecoders
PF angeschlossen. Die beiden Enden der Feinteilerkette
sind außerdem  über je einen Polaritätsdetektor PD1 bzw.
PD2 an zwei Steuereingänge SE1 bzw. SE2 des Schieberegisters SR angeschlossen. Mit den Polaritätsdetektoren
PD1 und PD 2 wird ermittelt, ob die jeweils an den Enden der Feinteilerkette auftretenden Spannungswerte gleiche oder verschiedene Polarität aufweisen. Solange an beiden Enden der Feinteilerkette Spannungswerte gleicher Polarität auftreten, wird das taktweise Verschieben eines Schalterschließsignals durch das Schieberegister SR weitergeführt. Die Schalter S1 bis S8 werden dann der Reihe nach einzeln in den leitenden Zustand geschaltet, beispielsweise beginnend bei S1. Sobald mittels der Polaritätsdetektoren PD1 und PD2 festgestellt wird, daß die Spannungswerte an den beiden Enden der Feinteilerkette unterschiedliche Polarität aufweisen, wird die Verschiebung des Schalterschließsignals im Schieberegister SR angehalten, so daß der gerade leitend geschaltete Schalter, bei dem in Fig. 13 gezeigten Beispiel der Schalter S5, geschlossen bleibt, während alle anderen Schalter geöffnet sind.

Zur nachfolgenden Erläuterung der Arbeitsweise des in Fig. 13 gezeigten A/D-Wandlers wird davon ausgegangen, daß bei dem gerade existierenden Analogsignalwert eine Spannungsauslöschung in der Mitte des Widerstandes RG5 auftritt. Dann weisen das obere Ende von RG5 und alle darüber liegenden Spannungsteilerpunkte positive Spannungswerte und das untere Ende von RG5 und die darunter liegenden Spannungsteilerpunkte negative Spannungswerte auf. Dabei ist weiterhin angenommen, daß bei dem Betrag der an die Modulatoren M1 und M2 angelegten Gleichspannungen +G und -G über jedem der Widerstände RG1 bis RG7 eine Spannung von 0,1 V abfällt. Genau dieser Spannungswert wird dem am Verbindungspunkt X auftretenden Spannungswert im Addierer A negativ überlagert. Wenn man einmal annimmt, daß gerade der Schalter S1 geschlossen ist, dann heißt das, daß von der am Verbindungspunkt X auftretenden Spannung, die über den geschlossenen Schalter S1 vom oberen Ende von RG1 abgenommen wird, mit Hilfe des Addierers A
eine Spannung von 0,1 V abgezogen wird. Die am unteren Ende
der Feinteilerkette anliegende Spannung ist daher um
den Spannungsabfall an RG1 niedriger als die am oberen
Ende von RG1 auftretende Spannung. Mit Hilfe des Addierers
A bildet man also über der Feinteilerkette immer diejenige Spannung nach, die über den Enden desjenigen Widerstandes der Grobteilerkette auftritt, dessen zugehöriger
Schalter gerade geschlossen ist.

Eine alternative Möglichkeit besteht darin, die Schalter
S1 bis S8 ausgangsseitig nur mit dem oberen Endpunkt der
Feinteilerkette zu verbinden und jedem Widerstand der
Grobteilerkette an seinem unteren Ende einen weiteren
Schalter zuzuordnen und diese weiteren Schalter gemeinsam mit dem unteren Ende der Feinteilerkette zu verbinden.
Für diesen Fall kann der Addierer A wegfallen, ist jedoch
die doppelte Anzahl Schalter erforderlich.

Da bei dem betrachtenden Analogsignalwert an beiden Enden
des Widerstands RG1 ein positiver Spannungswert erscheint,
wobei der Spannungswert am unteren Ende von RG1 größer
ist als die dem Addierer A zugeführte negative Überlagerungsspannung VN (im Beispiel: - 0,1 V), stellen die
beiden Polaritätsdetektoren PD1 und PD2 gleiche Polarität
der Spannungswerte an den beiden Enden der Feinteilerkette
fest. Daher wird das Schalterschließsignal im Schieberegister SR vom Ausgang A1 zum Ausgang A2 verschoben,
woraufhin der Schalter S2 leitend geschaltet und der
Schalter S1 wieder geöffnet wird. Dieses Verschieben des
Schalterschließsignals setzt sich fort, bis der Schalter
S5 leitend geschaltet ist. Da die Spannungsauslöschung nach der für diese beispielsweise Betrachtung gemachten
Annahme in der Mitte des Widerstandes RG5 auftritt, ist
die an seinem oberen Ende auftretende Spannung positiv,
allerdings um einen Betrag, der kleiner ist als der
Spannungsabfall von 0,1 V über diesem Widerstand RG5.
Nach Überlagerung des negativen Spannungswertes -0,1 V
im Addierer tritt daher am unteren Ende der Feinteilerkette ein negativer Spannungswert auf. Die beiden Polaritätsdetektoren PD1 und PD 2 stellen daher unterschiedliche Polarität an den beiden Enden der Feinteilerkette fest, was dazu führt, daß die Verschiebung
des Schalterschließsignals im Schieberegister SR beendet
wird. Schalter S5 bleibt daher leitend geschaltet, während
alle anderen Schalter geöffnet sind. Der über dem Widerstand RG5 auftretende Spannungsverlauf, der irgendwo entlang dieses Widerstandes den Wert Null aufweist und dort
seine Polarität wechselt, wird nun gewissermaßen an die
Feinteilerkette übergeben. Um auf Seiten der Feinteilerkette eine höhere Empfindlichkeit zu erreichen, wird der
vom Schalter S5 übergebene Spannungswert im Verstärker
VF2 verstärkt, beispielsweise um den Faktor 10. Das am
Ausgang des Addierers A auftretende Spannungssignal wird
im Verstärker VF3 um denselben Faktor verstärkt. Ist der
Addierer A als verstärkender Addierer ausgebildet, wird
zum Verstärker VF2 ein Verstärker VF1 in Reihe geschaltet,
der die gleiche Vestärkung wie der Addierer A aufweist.

Der über den Schalter S5 auf die Feinteilerkette gegebene
Spannungsverlauf wird mit Hilfe des Fein-Prioritätsdecoders PF auf die Lage des Spannungsnullpunktes untersucht. Am Ausgang dieses Fein-Prioritätsdecoders PF steht
dann in dualcodierte Weise ein Binärwertmuster zur Verfügung, das den Ort des Spannungsnullwertes auf der Feinteilerkette kennzeichnet.

Der Ausgang Ax des Schieberegisters SR, an dem das
Schalterschließsignal stehen bleibt, wenn unterschiedliche Polaritäten an den beiden Enden der Feinteilerkette anliegenden Spannungen festgestellt werden, kennzeichnet denjenigen Widerstand der Grobteilerkette, an
dem die Spannungsauslöschung und somit der Spannungswert
Null auftritt. Die Lage dieses Ausgangs gibt eine Grobkennzeichnung des zu digitalisierenden Analogsignalwertes. Vom Grob-Prioritätsdecoder PG wird in dualcodierter Weise ein diesem Analogsignal-Grobwert entsprechendes Bitmuster abgegeben.

Am Ende dieser Analog-Digital-Umwandlung sind am Ausgang
des Grob-Prioritätsdecoders PG die höherwertigen Bits
(MSB) und am Ausgang des Fein-Prioritätsdecoders PF
die niederwertigen Bits (LSB) des digitalisierten Analogsignalwertes verfügbar.

Hans Werba

Passau

22. März 1985

K 22 381K/6eb


Analog/Digital-Wandlung


## Patentansprüche


1.    Analog/Digital-Wandler mit einer von der erforderlichen Quantisierungsfeinheit abhängenden Anzahl Schwellenwertschaltungen (SW1, SW2, ...), deren Eingängen (E1, E2...)
das zu digitalisierende Analogsignal zugeführt wird und
an deren Ausgängen (A1, A2,...) das digitalisierte Signal
verfügbar ist,
dadurch  g e k e n n z e i c h n e t ,
daß den Eingängen (E1, E2...) der Schwellenwertschaltungen
(SW1, SW2...) eine Modulatorschaltung (AM) vorgeschaltet
ist, in der das zu digitalisierende Analogsignal auf eine
frequenzkonstante Trägerfrequenz in Amplitudenmodulation
aufmoduliert wird.


2.    Analog/Digital-Wandler nach Anspruch 1, dadurch gekennzeichnet, daß jeder Schwellenwertschaltung (SW1, SW2...)
ein Speicher (SP1, SP2,...) nachgeschaltet ist, in den das
binäre Ausgangssignal der je zugehörigen Schwellenwertschaltung (SW1, SW2...) unter Steuerung eines von der Trägerfrequenz abgeleiteten Taktes (T) einlesbar ist.

3.    Analog/Digital-Wandler nach Anspruch 1 oder 2, dadurch gekennzeichnet, daß jede Schwellenwertschaltung (SW1, SW2...) eine Diodenanordnung (D1, D2) aufweist, in der der jeweilige Schaltschwellenwert unter Ausnutzung des Dioden eigenen Schwellenverhaltens gebildet wird.

4.    Analog/Digital-Wandler nach Anspruch 3, dadurch gekennzeichnet, daß der je erforderliche Schwellenwert durch Hintereinanderschaltung einer Anzahl von Dioden gebildet wird, wobei den Schwellenwert die Summe der Kniespannungen der Dioden bildet.

5.    Analog/Digital-Wandler nach Anspruch 3, dadurch gekennzeichnet, daß der je erforderliche Schwellenwert durch eine vorgespannte Diode (D2) gebildet wird, wobei die Vorspannung dem um die Diodenkniespannung verminderten Schwellenwert entspricht.

6.    Analog/Digital-Wandler nach Anspruch 5, dadurch gekennzeichnet, daß jede Schwellenwertschaltung (SW1, SW2...) zwei gegensinnig hintereinandergeschaltete Dioden (D1, D2) aufweist,
daß an den Verbindungspunkt (V) zwischen den beiden Dioden (D1, D2) eine erste Stromquelle (R2) angeschlossen ist,
daß das freie Ende der einen Diode (D2) den Eingang (E1) und das freie Ende der anderen Diode (D1) den Ausgang (A1) der Schwellenwertschaltung (SW1) bildet
und daß der Ausgang (A1) über eine zweite Stromquelle (R1) an eine Referenzspannungsquelle ($U_{ref1}$) und über eine Begrenzerdiodenanordnung (D3) an ein Bezugspotential vorzugsweise Masse angeschlossen ist.

7. Analog/Digital-Wandler nach Anspruch 6, dadurch gekennzeichnet, daß mindestens eine der beiden Stromquellen durch einen Widerstand (R1, R2) gebildet ist.

8. Analog/Digital-Wandler nach einem der Ansprüche 2 bis 7, dadurch gekennzeichnet, daß zwischen den Ausgang einer jeden Schwellenwertschaltung (SW1, SW2...) und den zugehörigen Speicher (SP1, SP2...) ein Kondensator (C1, C2...) geschaltet ist.

9. Analog/Digital-Wandler mit einer von der erforderlichen Quantisierungsfeinheit abhängenden Anzahl Schwellenwertschaltungen (SW1, SW2,...), deren Eingängen (E1, E2...) das zu digitalisierende Analogsignal zugeführt wird und an deren Ausgängen (A1, A2,...) das digitalisierte Signal verfügbar ist, dadurch gekennzeichnet, daß die Schwellenwertschaltungen(SW1, SW2...) je nach einem der Ansprüche 2 bis 7 ausgebildet sind.

10. Analog/Digital-Wandler nach einem der Ansprüche 1 bis 9, dadurch gekennzeichnet,
daß jede Schwellenwertschaltung (SW1, SW2...) zwei Schwellenwertstufen mit identischem Schwellenwert aufweist, die unter gemeinsamer Taktsteuerung im Multiplexbetrieb abwechselnd im Gegentakt aktivierbar und entaktivierbar sind, wobei der zeitliche Abstand der Umschalttaktimpulse bis auf einen Wert reduzierbar ist,
der der halben Zeitdauer der von den Schwellenwertstufen für die Digitalisierung benötigten Zeit entspricht.

11.    Verfahren zur Analog/Digital-Wandlung, dadurch gekennzeichnet,

-  daß ein Trägerfrequenzsignal mit dem zu digitalisierenden Analogsignal amplitudenmoduliert und das modulierte Trägerfrequenzsignal hinsichtlich seiner Amplitude
   bewertet wird,

-  daß ein Bezugssignal mit der Frequenz des Trägerfrequenzsignals in einer von der erforderlichen Bit-Auflösung abhängenden Anzahl von Amplitudenstufen erzeugt
   wird,

-  daß das modulierte Trägerfrequenzsignal amplitudenmäßig
   mit jeder der einzelnen Amplitudenstufen des Bezugssignals verglichen wird,

-  und daß derjenigen Amplitudenstufe, mit deren Wert das
   modulierte Trägerfrequenzsignal übereinstimmt, ein erster
   binärer Logikwert (z.B. "0") und den anderen Amplitudenstufen der zweite binäre Logikwert (z. B. "1" zugeordnet
   wird.

12.    Verfahren nach Anspruch 11, d a d u r c h   g e -
k e n n z e i c h n e t , daß als Bezugssignal das unmodulierte Trägerfrequenzsignal verwendet wird.

13.    Verfahren nach Anspruch 11, d a d u r c h   g e -
k e n n z e i c h n e t ,
-  daß als Bezugssignal ein zweites amplitudenmoduliertes
   Trägerfrequenzsignal verwendet wird, das durch Amplitudenmodulation des Trägerfrequenzsignals mit dem Analogsignal in einer Phasenlage entsteht, die derjenigen Phasenlage entgegengesetzt ist, mit der die Amplitudenmodulation des ersten modulierten Trägerfrequenzsignals vorgenommen wird,

- daß beide modulierten Trägerfrequenzsignale in einer Anzahl von Relativ-Amplitudenstufen erzeugt werden,
- und daß jede Relativ-Amplitudenstufe des einen modulierten Trägerfrequenzsignals mit je einer zugeordneten Relativ-Amplitudenstufe des anderen modulierten Trägerfrequenzsignals verglichen wird,

wobei die niedrigste Relativ-Amplitudenstufe des einen
modulierten Trägerfrequenzsignals mit der höchsten Relativ-Amplitudenstufe des anderen modulierten Trägerfrequenzsignals, die zweitniedrigste Relativ-Amplitudenstufe
des einen modulierten Trägerfrequenzsignals mit der zweithöchsten Relativ-Amplitudenstufe des anderen modulierten
Trägerfrequenzsignals usw. verglichen werden.

14. Verfahren nach einem der Ansprüche 11 bis 13,
d a d u r c h   g e k e n n z e i c h n e t , daß das
Bezugssignal und das damit zu vergleichende modulierte Trägerfrequenzsignal in gleicher Phasenlage auf Amplitudengleichheit verglichen werden.

15. Verfahren nach einem der Ansprüche 11 bis 13,
d a d u r c h   g e k e n n z e i c h n e t , daß das Bezugssignal und das damit zu vergleichende modulierte Trägerfrequenzsignal in entgegengesetzter Phasenlage auf gegenseitige Auslöschung verglichen werden.

16. Analog/Digital-Wandler mit einer von der erforderlichen Quantisierungsfeinheit abhängenden Anzahl Bewertungsschaltungen (B1,...., B4), von deren Ausgängen ein dem
Analogsignal entsprechendes Bitmuster ableitbar ist,
d a d u r c h   g e k e n n z e i c h n e t ,
- daß eine Modulatorschaltung (M1, M2) vorgesehen ist, in der das zu digitalisierende Analogsignal auf ein
Trägerfrequenzsignal in Amplitudenmodulation aufmoduliert wird,

- daß das amplitudenmodulierte Trägerfrequenzsignal auf
  die Bewertungsschaltungen (B1,..., B4) gegeben wird, in
  denen das amplitudenmodulierte Trägerfrequenzsignal
  amplitudenmäßig bewertet wird,

- daß jede der Bewertungsschaltungen (B1, ..., B4) durch
  eine Amplitudenvergleichsschaltung mit einem ersten Eingang (E11, ... E14) und mit einem zweiten Eingang (E21,
  ..., E24) gebildet ist, deren erstem Eingang (E11, ...,
  E14) das amplitudenmodulierte Trägerfrequenzsignal und
  deren zweitem Eingang (E21, ..., E24) das nicht-modulierte Trägerfrequenzsignal nach einer abgestuften
  spannungsmäßigen Herabteilung auf eine für jede der Amplitudenvergleichsschaltungen (B1, ..., B4) verschiedene Teilungsstufe zugeführt wird,

- und daß dem Ausgangssignal derjenigen Amplitudenvergleichsschaltung (B1, ..., B4), an deren beiden Eingängen (E11, E21; ...; E14, E24) gleiche Amplituden auftreten, ein erster binärer Logikwert (z. B. "0"), und dem
  Ausgangssignal einer jeden Amplitudenvergleichsschaltung (B1, ..., B4), an deren beiden Eingängen (E11,
  E21; ...; E14, E24) unterschiedliche Amplituden auftreten, der andere binäre Logikwert (z. B. "1") zugeordnet
  ist.

17. Analog/Digital-Wandler nach Anspruch 16,
d a d u r c h   g e k e n n z e i c h n e t ,
- daß das amplitudenmodulierte Trägerfrequenzsignal sämtlichen ersten Eingängen (E11, ..., E14) direkt zugeführt wird,
- daß das nicht-modulierte Trägerfrequenzsignal einer
  Spannungsteiler-Widerstandskette (R1, ..., R4) zugeführt wird,
- und daß jeder der zweiten Eingänge (E21, ..., E24) mit
  einem anderen Teilerpunkt der Spannungsteiler-Widerstandskette (R1, ..., R4) verbunden ist.


18. Analog/Digital-Wandler nach Anspruch 16 oder 17,
d a d u r c h   g e k e n n z e i c h n e t , daß das
nicht-modulierte Trägerfrequenzsignal und das amplitudenmodulierte Trägerfrequenzsignal den beiden Eingängen
(E11, E21; ...; E14, E24) einer jeden Amplitudenvergleichsschaltung (B1, ..., B4) mit gleicher Phasenlage
zugeführt werden.


19. Analog/Digital-Wandler nach Anspruch 16 oder 17,
d a d u r c h   g e k e n n z e i c h n e t , daß das
nicht-modulierte Trägerfrequenzsignal und das amplitudenmodulierte Trägerfrequenzsignal den beiden Eingängen
(E11, E21; ...; E14, E24) einer jeden Amplitudenvergleichsschaltung (B1, ..., B4) mit entgegengesetzter Phasenlage zugeführt werden.

20.     Analog/Digital-Wandler mit einer von der
erforderlichen Quantisierungsfeinheit abhängenden Anzahl Bewertungsschaltungen (B1,..., B4), von deren
Ausgängen ein dem Analogsignalwert entsprechendes Bitmuster ableitbar ist,

d a d u r c h   g e k e n n z e i c h n e t ,

- daß zwei Amplitudenmodulatoren (M1, M2) vorgesehen
  sind, denen ein Trägerfrequenzsignal und das zu
  digitalisierende Analogsignal mit entgegengesetzten
  Phasen zugeführt werden,

- daß die Bewertungsschaltungen je durch eine Amplitudenvergleichsschaltung (B1,...,B4) mit einem ersten Eingang
  (E11,...,E14) und einem zweiten Eingang (E21,...E24)
  gebildet sind,

- daß den ersten Eingängen (E11, ..., E14) das amplitudenmodulierte Trägerfrequenzsignal vom einen Modulator (M1)
  nach einer abgestuften spannungsmäßigen Herabteilung
  auf eine für jede der Amplitudenvergleichsschaltungen
  (B1, ..., B4) verschiedene Teilungsstufe zugeführt wird,

- daß den zweiten Eingängen (E21, ..., E24) das amplitudenmodulierte Trägerfrequenzsignal vom anderen Modulator (M2) ebenfalls nach einer abgestuften spannungsmäßigen Herabteilung auf eine für jede der Amplitudenvergleichsschaltungen (B1, ..., B4) verschiedene Teilungsstufe zugeführt wird,

- wobei die Reihenfolge, in welcher den Eingängen der aufeinanderfolgenden Amplitudenvergleichsschaltungen (B1,
  ..., B4) zunehmend niedrigere herabgestufte Signalwerte
  zugeführt werden, für die ersten Eingänge (E11, ...,
  E14) und für die zweiten Eingänge (E21, ..., E24) entgegengesetzt ist,

- und daß dem Ausgangssignal derjenigen Amplitudenvergleichsschaltung (B1, ..., B4), an deren beiden Eingängen (E11, E21; ...; E14, E24) gleiche Amplituden auftreten, ein erster binärer Logikwert (z. B. "0"), und
dem Ausgangssignal einer jeden Amplitudenvergleichsstufe (B1, ..., B4), an deren beiden Eingängen (E11, E21;
...; E14, E24) unterschiedliche Amplituden auftreten,
der andere binärer Logikwert (z. B. "1") zugeordnet
ist.

21.     Analog/Digital-Wandler nach Anspruch 20,
d a d u r c h   g e k e n n z e i c h n e t ,

- daß zwischen den Ausgang des ersten Modulators (M1) und
ein Bezugspotential, z. B. Masse, eine erste Spannungsteiler-Widerstandskette (R11, ..., R14) und zwischen
den Ausgang des zweiten Modulators (M2) und das Bezugspotential eine zweite Spannungsteiler-Widerstandskette
(R21, ..., R24) geschaltet sind,
- und daß die ersten Eingänge (E11, ..., E14) der aufeinanderfolgenden Amplitudenvergleichsschaltungen (B1, ...,
B4) an in Richtung zunehmender Teilungsspannung aufeinanderfolgende Spannungsteilerpunkte der ersten Spannungs-
teiler-Widerstandskette (R11, ..., R14) und die zweiten
Eingänge (E21, ..., E24) der aufeinanderfolgenden Amplidenvergleichsschaltungen (B1, ..., B4) an in Richtung
abnehmender Teilungsspannung aufeinanderfolgende Spannungsteilerpunkte der zweiten Spannungsteiler-Widerstandskette (R21, ..., R24) angeschlossen sind.

22.     Analog/Digital-Wandler nach Anspruch 20 oder  21,
d a d u r c h   g e k e n n z e i c h n e t , daß die
amplitudenmodulierten Trägerfrequenzsignale von den beiden Modulatoren (M1, M2) den beiden Eingängen (E11, E21;
...; E14, E24) einer jeden Amplitudenvergleichsschaltung
(B1, ..., B4) mit gleicher Phase zugeführt werden.

23. Analog/Digital-Wandler nach Anspruch 20 oder 21,
d a d u r c h   g e k e n n z e i c h n e t , daß die
amplitudenmodulierten Trägerfrequenzsignale von den beiden Modulatoren (M1, M2) den beiden Eingängen (E11, E21;
...; E14, E24) einer jeden Amplitudenvergleichsschaltung
(B1, ..., B4) mit entgegengesetzter Phase zugeführt werden.

24. Analog/Digital-Wandler nach Anspruch 16 oder 22,
d a d u r c h   g e k e n n z e i c h n e t , daß die
Amplitudenvergleichsschaltungen (B1, ..., B4) je durch einen Differenzverstärker (D) gebildet sind.

25. Analog/Digital-Wandler nach Anspruch 19 oder 23,
d a d u r c h   g e k e n n z e i c h n e t , daß die
Amplitudenvergleichsschaltungen (B1, ..., B4) je durch
einen  Null-Detektor (N) gebildet sind.

26. Analog/Digital-Wandler nach einem der Ansprüche 16
bis 25,   d a d u r c h   g e k e n n z e i c h n e t ,
daß jeder Amplitudenvergleichsschaltung (B1, ..., B4) eine Schwellenwertschaltung (S) zur Definition der Schwelle
für die Unterscheidung zwischen den beiden binären Logikwerten ("0" und "1") nachgeschaltet ist.

27. Analog/Digital-Wandler nach einem der Ansprüche 16
bis 26, d a d u r c h   g e k e n n z e i c h n e t ,
daß das Trägersignal eine mit dem umzuwandelnden Analogsignal modulierte Gleichspannung ist.

28. Verfahren zur Analog/Digital-Wandlung,
d a d u r c h   g e k e n n z e i c h n e t ,
- daß  das zu digitalisierende Analogsignal in einer
  ersten Phasenlage einem ersten Trägerfrequenzsignal und in entgegengesetzter Phasenlage einem zweiten Trägerfrequenzsignal, dessen Frequenz mit derjenigen des
ersten Trägerfrequenzsignals übereinstimmt, dessen
Phasenlage jedoch zu derjenigen des ersten Trägerfrequenzsignals entgegengesetzt ist, amplitudenmäßig
aufmoduliert wird,

- daß das amplitudenmodulierte erste Trägerfrequenzsignal
  in das eine Ende und das amplitudenmodulierte zweite
  Trägerfrequenzsignal in das andere Ende einer Widerstandskette eingespeist werden,

- daß derjenige Spannungsteilerpunkt der Widerstandskette
  ermittelt wird, an dem sich eine Aufhebung der beiden
  Endes in die Widerstandskette eingespeisten Trägerfrequenzsignale ergibt,

- und daß diesem Spannungsteilerpunkt ein erster Binärwert ("0") und allen anderen Spannungsteilerpunkten der
  andere Binärwert ("1") zugeordnet wird und das so erhaltene Binärwertmuster den umgewandelten Analogsignalwert kennzeichnet.


29.    Verfahren zur Analog/Digital-Wandlung, d a d u r c h
g e k e n n z e i c h n e t ,
- daß das zu digitalisierende Analogsignal einem ersten
  Gleichspannungssignal einer ersten Polarität und einem
  zweiten Gleichspannungssignal gleichen Betrages, aber
  entgegengesetzter Polarität aufmoduliert wird,

- daß das amplitudenmodulierte erste Gleichspannungssignal in das eine und das amplitudenmodulierte
  zweite Gleichspannungssignal in das andere Ende einer
  Widerstandskette eingespeist werden,

- daß derjenige Spannungsteilerpunkt der Widerstandskette ermittelt wird, an dem sich eine Aufhebung der
  beiden Endes in die Widerstandskette eingespeisten Gleichspannungssignale ergibt,
- und daß diesem Spannungsteilerpunkt ein erster Binärwert ("0") und dem anderen Spannungsteilerpunkt der
  andere Binärwert ("1") zugeordnet wird und das so erhaltene Binärwertmuster den umgewandelten Analogsignalwert kennzeichnet.


30.    Analog/Digital-Wandler mit einer Widerstandskette
mit einer von der erforderlichen Quantisierungsfeinheit
abhängenden Anzahl Widerstände (R1 bis R7),
d a d u r c h   g e k e n n z e i c h n e t ,
- daß zwei Amplitudenmodulatoren (M1, M2) vorgesehen
  sind, denen je ein Trägerfrequenzsignal (T) und das
  zu digitalisierende Analogsignal (A) zugeführt werden,
  wobei das Trägerfrequenzsignal (T) und das Analogsignal
  (A) dem einen Amplitudenmodulator (M1) je in einer ersten
  Phase und dem anderen Amplitudenmodulator (M2) je in
  der entgegengesetzten Phase zugeführt werden,
- daß die Widerstandskette (R1 bis R7) zwischen die Ausgänge der beiden Amplitudenmodulatoren (M1, M2) geschaltet ist,
- und daß an die einzelnen Spannungsteilerpunkte der Widerstandskette (R1 bis R7) Null-Detektoren (V1 bis V7, P)
  angeschlossen sind, wobei deren Ausgangssignalen bei
  Null-Feststellung ein erster Binärwert ("0") und bei
  Nichtnull-Feststellung der andere Binärwert ("1") zugeordnet wird und das Binärwertmuster der Ausgangssignale
  der Null-Detektoren (V1 bis V7, P) den digitalisierten
  Analogsignalwert kennzeichnet.


31.    Analog/Digital-Wandler nach Anspruch 30,
d a d u r c h   g e k e n n z e i c h n e t , daß bei
einem Modulationsgrad $<$ 1 zwischen den Ausgang eines
jeden Amplitudenmodulators (M1, M2) und das je zugehörige Ende der Widerstandskette (R1 bis R7) ein Dämpfungswiderstand (RV1, RV2) geschaltet ist, der eine Spannungsverringerung bewirkt, die gleich der Amplitude des unmodulierten Trägers (T) minus dem Amplitudenhub ist.

32. Analog/Digital-Wandler mit einer Widerstandskette mit einer von der erforderlichen Quantisierungsfeinheit abhängenden Anzahl Widerstände (R1, bis R7), d a d u r c h   g e k e n n z e i c h n e t ,
- daß zwei Gleichspannungsmodulatoren (M1, M2) vorgesehen sind, die je mit dem zu digitalisierenden Analogsignal (A) als modulierendem Signal gespeist werden und denen Gleichspannungen (+G, -G) gleichen Betrages aber verschiedener Polarität als zu modulierende Signale zugeführt werden,
- daß die Widerstandskette (R1 bis R7) zwischen die Ausgänge der beiden Gleichspannungsmodulatoren (M1, M2) geschaltet ist,
- und daß an die einzelnen Spannungsteilerpunkte der Widerstandskette (R1 bis R7) Null-Detektoren (V1 bis V7, P) angeschlossen sind, wobei deren Ausgangssignalen bei Null-Feststellung ein erster Binärwert ("0" und bei Nicht-Null-Feststellung der andere Binärwert ("1") zugeordnet wird und das Binärwertmuster der Ausgangssignale der Null-Detektoren (V1 bis V7, P) den digitalisierten Analogsignalwert kennzeichnet.

33. Analog/Digital-Wandler nach einem der Ansprüche 30 bis 32, d a d u r c h   g e k e n n z e i c h n e t ,
- daß die Widerstandskette durch eine Grobteilerkette aus n-Widerständen (RG1 bis RG7) gleicher Widerstandswerte gebildet ist,
- daß an die einzelnen Spannungsteilerpunkte der Grobteilerkette (RG1 bis RG7) je ein steuerbarer Schalter (S1 bis S7) angeschlossen ist, deren nicht mit den

- 14 -

Spannungsteilerpunkten verbundene Seiten in einem gemeinsamen Verbindungspunkt (X) zusammengschaltet sind,

- daß die am gemeinsamen Verbindungspunkt (X) auftretende Spannung an das eine Ende einer eine Feinteilerkette bildenden zweiten Widerstandskette (RF1 bis RF7) angelegt wird, deren anderes Ende diese Spannung nach Überlagerung einer Gleichspannung , die gleich dem n-ten Teil der über der Grobteilerkette (RG1 bis RG7) anliegenden Spannung ist, zugeführt wird, und mit deren Spannungsteilerpunkten ebenfalls Null-Detektoren (PF) verbunden sind,

- daß die Steuereingänge der einzelnen Schalter (S1 bis S7) mit einer Schaltsteuerlogik (PD1, PD2, SR) verbunden sind, welche die an den beiden Enden der Feinteilerkette (RF1 bis RF7) auftretenden Spannungen polaritätsmäßig vergleicht und die Schalter (S1 bis S7) der Reihe nach einzeln leitend schaltet, um denjenigen Schalter auszuwählen, bei dessen Leitendschalten  an den Enden der Feinteilerkette (RF1 bis RF7) Spannungen unterschiedlicher Polarität auftreten,

- und daß das digitalisierte Analogsignal von dem Schalterzustandsmuster und dem Muster der Ausgangssignale der Null-Detektoren (PF) der Feinteilerkette (RF1 bis RF7) abgeleitet wird.

34.     Analog/Digital-Wandler nach Anspruch 33, d a d u r c h   g e k e n n z e i c h n e t , daß die Steuereingänge  der Schalter (S1 bis S7) an die Ausgänge eines Schieberegisters (SR) angeschlossen und von diesem taktweise der Reihe nach mit einem Schalterschließsignal beaufschlagt werden, bis dem Schieberegister (SR) das Auftreten von Spannungen gleicher Polarität an den Enden der Feinteilerkette (RF1 bis RF7) gemeldet wird.

35. Analog/Digital-Wandler nach einem der Ansprüche 32 bis 34, dadurch gekennzeichnet, daß die beiden Gleichspannungsmodulatoren (M1, M2) je durch einen Differenzverstärker gebildet sind, dessen einem Eingang das Analogsignal (A) und dessen anderem Eingang die zu modulierende Gleichspannung (+G, -G) zugeführt werden.

36. Analog/Digital-Wandler nach einem der Ansprüche 30 bis 35, dadurch gekennzeichnet, daß an die einzelnen Spannungsteilerpunkte Polaritätsinverter angeschlossen sind, die Eingangsspannungen beliebiger Polarität in Ausgangsspannungen nur einer einzigen Polarität umwandeln.

37. Analog/Digital-Wandler nach Anspruch 36, dadurch gekennzeichnet, daß die Polaritätsinverter je als Differenzverstärker (T1, T2) mit zwei Ausgängen (A1, A2) ausgebildet sind, deren einem Eingang (E1) die Eingangsspannung beliebiger Polarität und deren anderem Eingang (E2) eine Bezugsspannung zugeführt wird,
und daß beide Ausgänge (A1, A2) über je eine Diode (D1, D2) mit dem Setz-Eingang eines Flip-Flop (FF) verbunden sind, an dessen Ausgang bei einer Spannung Null am zugehörigen Spannungsteilerpunkt der erste Binärwert ("0") und bei einer von Null verschiedenen Spannung an diesem Spannungsteilerpunkt der andere Binärwert ("1") auftritt.

38. Analog/Digital-Wandler nach einem der Ansprüche 30 bis 37, dadurch gekennzeichnet, daß jedem Spannungsteilerpunkt ein Verstärker (V1 bis V7) nachgeschaltet ist.

39. Analog/Digital-Wandler nach einem der Ansprüche 30 bis 38, dadurch gekennzeichnet, daß die Spannungsteilerpunkte je mit dem Eingang eines Prioritätsdekoders (P) verbunden sind, wobei bei Verwendung einer
Grobteilerkette (RG1 bis RG7) und einer Feinteilerkette (RF1 bis RF7) jeder Kette ein eigener Prioritätsdetektor (PG, PF) nachgeschaltet ist.

40. Analog/Digital-Wandler nach einem der Ansprüche
17 bis 19, 21 bis 27 oder 30 bis 39,
d a d u r c h   g e k e n n z e i c h n e t ,
daß die Widerstände der Widerstandskette durch ohmsche
Widerstände, Induktivitäten und/oder Kapazitäten gebildet sind.

FIG. 1

$U_{ref_1}$

$R_1$

$D_1$  V  $D_2$

$A_1$

$E_1$

$D_3$

$R_2$

$-U_V$

**FIG. 2**

$R_8$  $R_9$

$E_{21}$  $E_{11}$

V

S

$A_1$

**FIG. 5**

$E_{21}$  $E_{11}$

D

**FIG. 6**

S

$A_1$

FIG. 3

FIG. 4

FIG. 7

FIG. 8

0155702

FIG.9

FIG. 10

a)

Analogsignal 0°
Träger 0°

$\hat{T}'$   $\hat{T}$

t

$\hat{T}$min

b)

$\hat{T}'$   $\hat{T}$

t

$\hat{T}$min

Analogsignal 180°
Träger 180°

R₁  R₂  R₃  R₄  R₅  R₆  R₇  R₈  R₉

- V        0        + V

FIG. 11

FIG. 12

8 / 8

FIG. 13